# EUROPEAN PATENT APPLICATION

(11) **EP 2 894 241 A1**
(43) Date of publication of application: **15.07.2015**
(21) Application number: 13835747.0
(22) Date of filing: 01.08.2013
(51) Int. Cl.: C25D 5/02, C09D 123/00, C23C 18/16, C23F 1/02, C25D 11/00, C25F 3/00

(54) **MASKING AGENT, AND METHOD FOR PRODUCING SURFACE-TREATED BASE**

(30) Priority: 10.09.2012 JP 2012198563
(71) Applicant: JE International Corporation, Nagoya-shi, Aichi 460-0002 (JP)
(72) Inventor: KONISHI, Yukio, Chikushino-shi Fukuoka 818-0024 (JP); KIM, Minsu, Nagakute-shi Aichi 480-1142 (JP)
(74) Representative: Chevalier, Renaud Philippe
(86) International application number: PCT/JP2013/070933
(87) International publication number: WO 2014/038325

(57) **Abstract**

Provided is a method for producing a surface treated base including a process of preparing a masking solution by heating a masking agent including paraffin to a temperature more than the melting point of the paraffin, a process of patterning the masking solution on a substrate to form a mask pattern, a process of surface treating the substrate having the mask pattern and a process of producing the surface treated base by removing the masking agent constituting the mask pattern using a refrigerant having a temperature less than the melting point of the paraffin. The masking agent is readily removed without adversely affecting the formed pattern after surface treatment.

## Description

### TECHNICAL FIELD

The present invention disclosed herein relates to a masking agent used for coating (masking) a portion to be passivated during surface treating such as plating, etching, electrolytic polishing, anodizing, etc., and a method of forming a pattern using the masking agent.

### BACKGROUND ART

During conducting surface treatment such as plating, etching, etc., a masking agent is used to form a desired pattern. For example, a plating treatment is commonly conducted by wrapping the surface portion of a substrate excluding a part for plating with a masking tape and then conducting plating. As a particular masking tape, a polyolefin resin such as polypropylene (PP), polyethylene (PE), etc., or a base of polyethyleneterephthalate (PET) with an adhesive layer formed on one surface thereof may be commonly used in consideration of processability, chemical-resistance, etc.

The masking tape is required to have the properties that a masking tape is not exfoliated or peeled off during treating, a plating solution is not invade thereinto, the clearness of a plating line is good, stickiness is not generated at an attached portion and is easily exfoliated after use, an adhesive does not contaminate a plating solution, etc. In view of the above-described points, an adhesive with increased cohesiveness by cross-linking an isocyanate compound or a methylol compound to obtain a three-dimensional compound, or an adhesive obtained by blending a natural rubber or a modified natural rubber with an appropriate adhesive imparting agent, is used.

Meanwhile, the recycling (regenerating) of tape waste resources is recently conducted on the lift-up of environmental awareness. For example, Japanese Laid-open Patent Publication No. 2003-119441 discloses the development of a masking tape for plating having good masking properties on plating, having good exfoliation after plating, easily treated after use and good recycling properties by using an adhesive including a block copolymer, an adhesiveness imparting resin with a softening point of about 70-140°C, and an adhesiveness imparting resin with a liquid state at room temperature.

In addition, a method of forming a pattern by an etching treatment is commonly conducted by (1) coating a photosensitive resin composition on a metal substrate and exposing to print a pattern on a film resist on the metal substrate, (2) forming a resist pattern on the metal substrate by developing using an aqueous alkaline solution such as an aqueous sodium carbonate solution and (3) masking the resist pattern, etching the metal substrate and exfoliating/removing the resist pattern using an aqueous alkaline solution such as an aqueous sodium hydroxide solution. In a method of coating the photosensitive resin composition on the substrate, a photosensitive resin laminate (dry film resist) obtained by laminating a support film, a photosensitive resin composition layer and a passivation layer as occasion demands one by one may be used.

Meanwhile, for the formation of a pattern having a narrow pitch with high yield according to the decrease of the interval of wirings on a printed circuit board, a dry film resist which has high definition and of which cured resist layer is easily removed, is required. For example, Japanese Laid-open Patent Publication No. 2011-081031 discloses a photosensitive resin composition including an alkaline-soluble polymer, a photopolymerizable compound and a photopolymerization initiator.

In addition, in a related art, a non-treating surface of a substrate is wrapped with a masking tape, surface treatment is conducted, and the masking tape is exfoliated using a certain exfoliating apparatus (for example, Japanese Laid-open Patent Publication No. 2004-43852).

### DISCLOSURE OF THE INVENTION

### TECHNICAL PROBLEM

However, according to a plating method using a masking tape as in Japanese Laid-open Patent Publication No. 2003-119441, the masking tape is generated as a waste resource after plating. According to the method disclosed in Japanese Laid-open Patent Publication No. 2003-119441, the recycling degree may be improved, and a plastic material (recycled plastic) may be formed, however, the recycling of the waste resource as the masking tape is difficult.

Besides, in the plating treatment using a common masking tape, the coexistence of the adhesion and exfoliation is insufficient, and the degree of precision of plating finishing is also insufficient.

In addition, in an etching method using a dry film as disclosed in Japanese Laid-open Patent Publication No. 2011-081031, the dry film is generated as a waste material after conducting an etching treatment, thereby inducing a great load on the environment.

In addition, in the etching treatment, an aqueous alkaline solution used to remove a cured resist layer after etching may adversely affect including discoloration of a metal pattern.

As described above, surface treatment maintaining the accuracy of the surface treatment such as plating and etching while having little load on the environment is not known.

The present invention provides a method of easily removing a masking agent without inducing adverse effects on a pattern formed after surface treatment. In addition, the present invention also provides a method of recovering/reusing a removed masking agent. In addition, the present invention also provides a method for forming a mask pattern having sufficient resolution, which may be easily removed.

In addition, as the shape of an object to be surface treated such as an electronic part is complicated recently, the requirement of the surface treatment with respect to a complicated and small part is increasing. However, by the technique disclosed in Japanese Laid-open Patent Publication No. 2004-43852, masking is conducted using a masking tape, and the masking of a complicated and small non-treating surface is difficult. In addition, if the masking tape is attached only on attachable parts and immersion in a plating solution is performed, the plating solution is coated even on unnecessary parts, and the loss of a plating material may be induced.

In addition, an exfoliation apparatus for exfoliating the masking tape is necessary, and costs and time for the exfoliation of the masking tape may be increased.

Here, the present invention also provides to solve the above-described tasks a coating apparatus and a coating method for forming masking on a complicated and small non-treating surface, a removing apparatus and a removing method for easily removing a masking agent, and a coating removing system.

### TECHNICAL SOLUTION

The inventors of the present invention repeated close examination to solve the above-described tasks. Consequently, the inventors found that the tasks could be solved by using a masking agent including paraffin as a masking agent for surface treatment and completed the present invention.

Embodiments of the present invention provide methods for producing a surface treated base including a process of preparing a masking solution by heating a masking agent including paraffin to a temperature more than the melting point of the paraffin, a process of patterning the masking solution on a substrate to form a mask pattern, a process of surface treating the substrate having the mask pattern and a process of producing the surface treated base by removing the masking agent constituting the mask pattern using a refrigerant having a temperature less than the melting point of the paraffin.

In other embodiments of the present invention, methods for forming a mask pattern include a process of preparing a masking solution by heating a masking agent including paraffin to a temperature more than the melting point of the paraffin and a process of patterning the masking solution on a substrate to form the mask pattern.

In still other embodiments of the present invention, masking agents include paraffin.

### ADVANTAGEOUS EFFECTS

According to the present invention, a masking agent including paraffin with excellent chemical-resistance may be easily removed by a refrigerant, and adverse effects on a pattern formed may be prevented. In addition, the masking agent may be easily recovered and reused after use, and surface treatment imposing little burden on the environment may be possibly conducted. Further, a mask pattern formed using the masking agent including the paraffin has sufficient resolution and may be easily removed. Thus, a simple surface treatment with high degree of precision may be possible.

### BRIEF DESCRIPTION OF THE DRAWINGS

FIG. 1 is a schematic diagram illustrating a method for forming a surface treated base according to an embodiment of the present invention;
FIG. 2 is a schematic diagram illustrating a method for forming a surface treated base according to an embodiment of the present invention;
FIG. 3 is a schematic diagram illustrating a method for forming a surface treated base according to an embodiment of the present invention;
FIG. 4 is a schematic diagram illustrating a method for forming a surface treated base according to an embodiment of the present invention;
FIG. 5 is the photographic image of a mask pattern obtained in Example 1-1. The dimension of the outer side of the mask pattern (black part) is 37 mm (width) x 95 mm (length) in FIG. 5;
FIG. 6 is the optical microscope image of a mask pattern obtained in Example 1-2, where (A) is the optical microscope image of the mask pattern at an edge part, and (B) is the optical microscope image of the mask pattern at a line part;
FIG. 7 is the optical microscope image of a mask pattern obtained in Example 1-3;
FIG. 8 is an optical microscope image of a mask pattern obtained in Example 1-4;
FIG. 9 illustrates a coating removing system according to Embodiment A of the present invention;
FIG. 10(A) is a drawing illustrating a coating process of a coating material on an object to be coated by an inkjet part of a coating apparatus according to Embodiment A, and FIG. 10(B) is a drawing illustrating the state of the object to be coated after coating;
FIG. 11 is a cross-sectional view illustrating a discharging state of a coating material from an inkjet part;
FIG. 12 is a perspective view illustrating a schematic configuration of a third rotationally moving part of a control part;
FIG. 13 illustrates a plating treating unit;
FIG. 14 is a flowchart illustrating a method of plating treatment by the plating treating unit in FIG. 13;
FIG. 15 is a drawing illustrating an object to be coated after finishing each process by the plating treating unit shown in FIG. 13. FIG. 15(A) is an initial state, FIG. 15(B) is a state after finishing a discharging process, FIG. 15(C) is a state after being immersed in a plating solution and FIG. 15(D) is a state of an object to be coated after finishing a cooling removing process;
FIG. 16 is a drawing when a plurality of inkjet parts are provided;
FIG. 17 is a drawing when the row of the nozzles of an inkjet part is slanted with respect to a Y-direction;
FIG. 18 is a drawing illustrating a coating removing system according to Embodiment B;
FIG. 19 is a drawing illustrating an object to be coated after finishing a cooling removing process according to Embodiment B; and
FIG. 20 is a drawing illustrating a coating removing system according to Embodiment C.

### MODE FOR CARRYING OUT THE INVENTION

Preferred embodiments of the present invention will be described below in more detail with reference to the accompanying drawings. The same reference numerals refer to the same elements in the explanation of drawings, and repeated explanation will be omitted. The present invention may, however, be embodied in different forms and should not be constructed as limited to the embodiments set forth herein. In the drawings, the dimensions of elements are exaggerated for convenience of explanation and may be different from practical proportion.

According to an embodiment of the present invention, a method for producing a surface treated base including a process of preparing a masking solution by heating a masking agent including paraffin to a temperature more than the melting point of the paraffin, a process of patterning the masking solution on a substrate to form a mask pattern, a process of surface treating the substrate having the mask pattern and a process of producing the surface treated base by removing the masking agent constituting the mask pattern using a refrigerant having a temperature less than the melting point of the paraffin, is provided.

In the present disclosure, the term "surface treatment" means the modification of the surface of a substrate by a physical or chemical method. The method of the surface treatment is not specifically limited, and a chemical modification method, for example, plating, etching, electroforming, surface roughening, etc. and a physical modification method, for example, polishing, sputtering, etc. may be used. In this embodiment, any one of the methods may be applied. Hereinafter, plating and etching will be explained in detail as typical embodiments.

### [First embodiment]

In an embodiment of the present invention, surface treatment is a plating treatment. That is, according to an embodiment of the present invention, a method for producing a surface treated base including a process of preparing a masking solution by heating a masking agent including paraffin to a temperature more than the melting point of the paraffin (masking solution preparing process), a process of patterning the masking solution on a substrate to form a mask pattern (masking solution patterning process), a process of plating treating the substrate having the mask pattern to form a metal layer on the non-forming part of the mask pattern (plating treating process) and a process of removing the masking agent constituting the mask pattern using a refrigerant having a temperature less than the melting point of the paraffin (masking agent removing process), is provided.

This embodiment is characterized in using a masking agent including paraffin as a masking agent. That is, according to an embodiment of the present invention, a masking agent including paraffin is provided. As described above, in a plating method using a common masking tape, the reuse of the waste resource of the masking tape after plating is difficult, and the masking tape is an industrial waste imposing a burden on the environment. In addition, after exfoliating the tape, chemical treatment may be applied for surface washing, and in this case, industrial waste such as an organic solvent, an acidic or alkaline washing solution may be produced. In addition, the coexistence of the adhesion and exfoliation of the masking tape is not always sufficient, a plating solution may intrude a separated part/exfoliated part of the masking tape during plating, and the degree of precision of plating finishing is insufficient.

In contrast, the masking agent including the paraffin used in this embodiment has good chemical-resistance to a plating solution, and a coated part and a base may attach closely after coating the masking agent. Thus, a plating solution may not intrude between the mask pattern and the substrate during plating, and the degree of precision of plating finishing may be improved. In addition, the masking agent of this embodiment may be easily removed after plating by using a refrigerant. Further, the masking agent may be recovered and reused after plating. Therefore, plating treatment generating no adverse effects on a pattern formed and imposing little burden on the environment may be conducted.

First, the masking agent used in the preparation method of this embodiment will be explained.

### (Masking agent)

The masking agent according to the present invention includes paraffin and a colorant and other additives, as occasion demands.

In the present disclosure, paraffin is an alkane having at least 20 carbon atoms (saturated hydrocarbon chain with General Formula of CnH2n+2). Paraffin is chemically very stable and has excellent chemical-resistance (alkaline-resistance/acid-resistance) with respect to a surface treating agent such as an etching solution or a plating solution with high corrosiveness. Thus, a composition including the paraffin may be used as the masking agent during surface treating such as etching or plating. According to the surface treatment using the masking agent including the paraffin, a masking agent in a molten state is coated to form a mask pattern, surface treatment such as etching or plating is conducted, and the masking agent is removed by cooling to a temperature less than the melting point. In addition, the paraffin is favorable because it is highly safe to a human body, and the treating property of the masking agent may be improved by preparing the masking agent using the paraffin.

The paraffin used in the present invention is not specifically limited, is preferably a saturated hydrocarbon chain having 20 to 80 carbon atoms, and is more preferably a saturated hydrocarbon chain having 20 to 40 carbon atoms. In addition, the paraffin may be a linear chain or a branched chain. The paraffin may be formed using a homogeneous material; however is commonly a mixture of at least two kinds of saturated hydrocarbon chains (paraffin) having different carbon chains.

The number average molecular weight (Mn) of the paraffin is preferably about 220-480, is more preferably about 220-300, and is more preferably about 220-260. Thus, the melting point of the paraffin may be in a desired range, and the adhesion to a substrate and the exfoliating property during cooling may be improved.

In addition, an average carbon number of the paraffin is preferable about 20-40. Generally, as the carbon number increases, the melting point of the paraffin increases. Thus, the melting point of the paraffin may be in a desired range, and the adhesion to the substrate and the exfoliation property during cooling may be improved by changing the number of the carbon included.

The melting point of the paraffin is different according to the use thereof, and paraffin having a solid state at room temperature (about 25°C) is preferable. The melting point of the paraffin is preferably about 40°C and over and is more preferably about 50°C and over. The melting point of the paraffin is further more preferably about 60°C and over and is still further more preferably about 65°C and over. The removal of the masking agent or surface treatment (plating treatment, etching treatment), which will be described layer, is necessary to be conducted at a temperature less than the melting point of the paraffin. In this case, the removing of the masking agent obtained by including the paraffin and the surface treatment may be easily conducted, and the selection width of the treatment temperature is preferably wide. As the melting point decreases, the loss or exfoliation of the mask pattern is easily generated during the surface treatment. The melting point is particularly preferably about 75°C and over for the prevention of the defects. Meanwhile, the upper limit of the melting point is not specifically limited. In the case that the melting point is about 200°C and less, the coating of the masking agent obtained by including the paraffin may preferably be conducted in moderate conditions and using diverse coating apparatuses and coating methods. Generally, if the melting point of the paraffin increases, the contraction percentage thereof increases with the decrease of the temperature, and the paraffin may be easily split. The melting point is more preferably about 150°C and less in consideration of the above points. More preferably, the melting point is about 100°C and less, and particularly preferably, the melting point is about 85°C and less in consideration of the good exfoliation property of the masking agent after the surface treatment.

As the paraffin, paraffin wax prepared by separating from the effluent by the distillation under reduced pressure of petroleum and purifying regulated in JIS K 2235:2209, synthesized paraffin derived from petroleum mineral, synthesized wax, etc., may be used. PARAFFINWAX series produced by NIPPON SEIRO CO., LTD may be used as commercially available products.

The masking agent may not be composed of only the paraffin. The masking agent may be a masking composition including the paraffin, and colorant and other additives, as occasion demands.

The masking agent preferably includes the colorant. The paraffin is in a range of semi-transparent to white at room temperature, and by adding the colorant, the visibility of a mask pattern formed by the masking agent may be improved. The colorant is not specifically limited, and known pigments and/or dyes may be used.

As the pigment, for example, a magenta pigment such as Pigment Red 3, 5, 19, 22, 31, 38, 43, 48:1, 48:2, 48:3, 48:4, 48:5, 49:1, 53:1, 57:1. 57:2, 58:4. 63:1, 81, 81:1, 81:2, 81:3, 81:4, 88, 104, 108, 112, 122, 123, 144, 146, 149, 166, 168, 169, 170, 177, 178, 179, 184, 185, 208, 216, 226, 257, Pigment Violet 3, 19, 23, 29, 30, 37, 50, 88, Pigment Orange 13, 16, 20, 36, etc., a cyan pigment such as Pigment Blue 1, 15, 15:1, 15:2, 15:3, 15:4, 15:6, 16, 17-1, 22, 27, 28, 29, 36, 60, etc., a green pigment such as Pigment Green 7, 26, 36, 50, etc., a yellow pigment such as Pigment Yellow 1, 3, 12, 13, 14, 17, 34, 35, 37, 55, 74, 81, 83, 93, 94, 95, 97, 108, 109, 110, 137, 138, 139, 153, 154, 155, 157, 166, 167, 168, 180, 185, 193, etc., a black pigment such as Pigment Black 7, 28, 26, etc., a white pigment such as Pigment White 6, 18, 21, etc. may be used according to the purpose.

As the dye, an oil soluble dye substantially insoluble in water is preferable. For example, C.I. solvent black 3, 7, 27, 29 and 34, C.I. solvent yellow 14, 16, 19, 29, 30, 56, 82, 93 and 162, C.I. solvent red 1, 3, 8, 18, 24, 27, 43, 49, 51, 72, 73, 109, 122, 132 and 218, C.I. solvent violet 3, C.I. solvent blue 2, 11, 25, 35, 67 and 70, C.I. solvent green 3 and 7, and C.I. solvent orange 2, etc., may be used. In addition, in the present disclosure, the oil soluble dye has solubility (amount of a dye soluble in about 100 g of water) of about 1 g and less, preferably, about 0.5 g and less, and more preferably, about 0.1 g and less in water at about 25°C.

The dye and/or pigment may be used solely or as a mixture of two or more.

When a colorant such as a pigment present in a solid state is used among the masking agent, the average diameter of the colorant particles is preferably about 1-20 µm, more preferably about 1-10 µm, more preferably about 1-5 µm, and more preferably about 1-2 µm. In the above-described range, the blocking of a head nozzle may be prevented, and the conservation stability of ink may be maintained when the masking agent is coated by an inkjet method.

The masking agent may include the additive such as a dispersing agent for improving the dispersibility of the colorant, a surfactant for controlling the surface tension of the masking agent, a viscosity controlling agent, an adhesiveness imparting agent to improve adhesiveness, a plasticizer for imparting flexibility, an antioxidant for imparting thermal stability, etc.

The amount of the paraffin in the masking composition as the masking agent is preferably from about 85 wt% to about 100 wt% based on the total amount of the masking agent (masking composition) for sufficiently exhibiting chemical-resistance, is more preferably from about 90 wt% to about 99.99 wt% for preventing chemical reaction with a plating solution, and is more preferably from about 95 wt% to about 99.99 wt% for further preventing chemical reaction with a plating solution.

The amount of the colorant in the masking composition may be appropriately selected according to the use, and is preferably about 0.01-10 wt%, is more preferably about 0.01-5 wt%, and is more preferably about 0.01-1 wt% based on the total amount of the masking composition in consideration of the dispersibility and the coloring property of the masking agent.

The amount of other additives in the masking composition is not specifically limited in a range not damaging the effects of the present invention and is commonly and preferably from about 0.1 parts by weight to about 10 parts by weight based on the total amount (100 parts by weight) of the paraffin and the colorant.

The preparation of the masking agent (masking composition) including the colorant and/or the additive may be conducted by mixing paraffin in a molten state and the colorant and/or additive using a dispersing apparatus such as a ball mill, a sand mill, an attritor, a roll mill, an agitator, a Henschel mixer, a colloidal mill, a sonic homogenizer, a pearl mill, a wet zet mill, a paint shaker, etc.

The viscosity of the masking agent is preferably about 5-30 mPa·s at about 80°C. In this range, diverse coating apparatuses and coating methods including an inkjet method may be applied. For example, in the case that the coating is conducted using the inkjet method, the viscosity of the masking agent after discharging/carbonizing may be changed according to an object (material of a lead frame, etc./surface finishing). Generally, the viscosity is preferably high in consideration of the prevention of ink flow after discharging, however if the viscosity is too high, the diffusion of the ink is not good, and the formation of a uniform coating surface may be difficult even though increasing resolution. Thus, the viscosity is preferably about 5-20 mPa·s, and is more preferably about 8-20 mPa·s. The viscosity of the masking agent may be controlled to a desired range by controlling the composition of the paraffin (the kind and the amount ratio of the saturated hydrocarbon chain) constituting the masking agent or by adding a viscosity controlling agent.

In the present invention, the viscosity of the masking agent is an average of measured values five times per 100 seconds after setting the temperature to a certain temperature using a temperature dependent rotary type viscometer (for example, TVB-35 manufactured by TOKI SANGYO CO., LTD.). Measuring conditions include a fore-end speed of about 10 (l/s) and a temperature elevation rate of about 5°C/5 seconds.

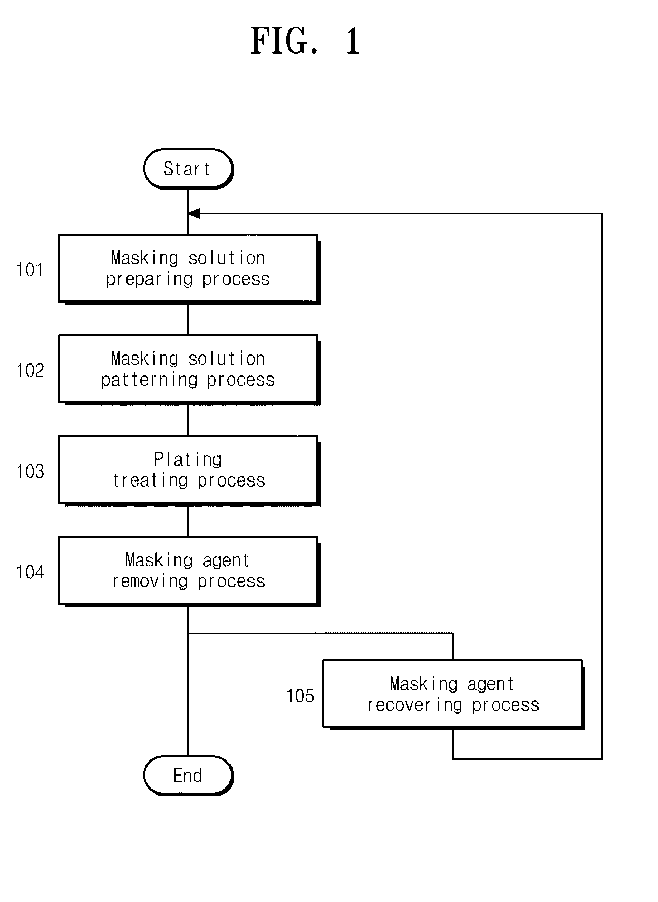

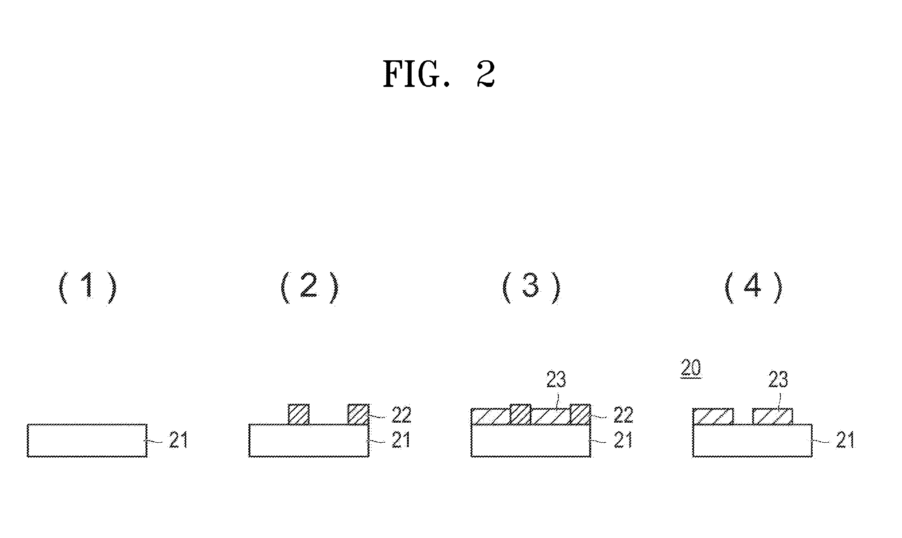

Hereinafter, each process constituting a producing method using the masking agent will be explained referring to FIGS. 1 and 2. In addition, a mask pattern is formed by the producing process of the masking solution and the patterning process of the masking solution. Thus, according to an another embodiment of the present invention, a method for producing a mask pattern including a process of preparing a masking solution by heating a masking agent including paraffin to a temperature more than the melting point of the paraffin (masking solution preparing process), and a process of forming the mask pattern by patterning the masking solution on a substrate (masking solution patterning process), is provided.

### (1) Masking solution preparing process (101 of FIG. 1)

In the present invention, a masking agent including paraffin is heated to a temperature more than the melting point of the paraffin to prepare a masking solution. Particularly, the masking agent including only the paraffin or the masking agent as a masking composition including the paraffin is heated to the temperature more than the melting point (of the paraffin) to obtain a masking solution. In the case of using the masking composition, the paraffin is heated to a molten state, and a colorant and/or other additives are added and mixed using a mixing and dispersing apparatus. The mixture thus obtained may be used as the masking solution as it is. The heating apparatus of the masking agent is not limited, and a commonly known heating apparatus may be used. For example, the masking agent may be heated and melted using an ink supplying apparatus provided with heating and melting function attached to a hot melt ink printing apparatus. During heating and melting, the masking agent may be stirred.

The heating temperature is not specifically limited only if higher than the melting point of the paraffin. Here, if the masking agent includes many kinds of paraffin, the "melting point of paraffin" means the lowest melting point of a kind of the paraffin included in the masking agent. Preferably, the heating is preferably conducted to the melting point + about 20°C and over in consideration of surface tension and is more preferably conducted to the melting point + about 30°C and over in consideration of viscosity. Meanwhile, the upper limit of the heating temperature is not specifically limited only if less than the boiling point of the paraffin and is preferably less than about 180°C in consideration of heat-resistance of a coating apparatus (for example, inkjet head).

### (2) Masking solution patterning process (102 of FIG. 1)

Then, the masking solution is patterned on a substrate 21 as shown in (2) of FIG. 2 to form a mask pattern 22. Particularly, the masking solution in a molten state obtained in a previous process is selectively coated on the substrate 21 and dried to form the mask pattern 22.

The coating apparatus of the masking solution is not specifically limited, and commonly used printing technique such as an inkjet method, a gravure printing, a gravure offset printing, a flexography printing, a screen printing, etc. may be used. Preferably, a printing method via direct output from electronic instruments such as a contactless type inkjet method (more particularly, inkjet method of piezo method) with respect to an object, may be used.

The temperature of the masking solution during coating is preferably the melting point + about 20°C and over and is more preferably the melting point + about 30°C in consideration of the improvement of coating property. Meanwhile, the upper limit is not specifically limited only if less than the boiling point of the paraffin and is preferably less than about 180°C in consideration of the heat-resistance of a coating apparatus (for example, inkjet head) and is more preferably less than about 140°C in consideration of the coating apparatus. In addition or alternatively, the temperature of the masking solution is more preferably less than the (melting point + about 50°C) of the masking agent.

After coating (printing) the masking solution on a base, cooling and drying are conducted as occasion demands to easily form a mask pattern, which is the patterned coating layer of the masking agent on the base. The drying temperature of the mask pattern is not specifically limited, however is preferably about 24-60°C for restraining the exfoliation of the mask pattern due to rapid contraction and is about 50-60°C for improving the diffusion of ink after coating. Meanwhile, the upper limit is not specifically limited only if less than the melting point of the paraffin constituting the masking agent, and is preferably about 24-50°C in consideration of the diffusion of the paraffin and is more preferably about 24-30°C in consideration of the formation of an edge.

In addition, after coating the masking solution on the substrate and drying, the substrate coated with the masking solution is preferably heated in an embodiment. That is, in an embodiment of the present invention, the process for forming the mask pattern includes a process of coating the masking solution on the substrate and a process of heating the substrate coated with the masking solution. The fluidity of the ink of the masking solution (masking agent) thus coated may increase, and dot shape ink may flow into the pores (gaps/grooves) between inks to decrease, reduce, and further eliminate the pores (gaps/grooves). In this case, the resolution of the mask pattern may be improved. Particularly, the mask pattern at an edge part may become smooth, and a smooth edge may be formed. Particularly, in the mask pattern formed at a pin connector, a sharp edge may be formed, and thus, the loss of a terminal shape may be prevented, linearity may be improved, and a smooth curve may be formed. In addition, the adhesion of the masking solution (masking agent) and the substrate may be improved. Generally, in the case that a hot melting ink such as paraffin wax is coated, the ink is preferably carbonized (coated) thick by dividing several times to decrease, reduce or eliminate (to improve coating density) the pores (gaps) between carbonized ink. However, according to the present invention, such a multi-coating process is not necessary because the pores (gaps) between inks may be decreased or prevented by a simple method of heating the substrate coated with the masking agent (masking solution). Thus, the amount used of the masking agent may be significantly decreased, and time required for coating treatment may be markedly decreased.

The heating temperature of the substrate (surface temperature of the substrate) coated with the masking solution is preferably about 70-110°C. In the case that the heating temperature is about 110°C and less, the fluidity of the coated masking solution (masking agent) is too high, and the deterioration of the degree of precision of the pattern by the collapse of the shape of the mask pattern may be prevented. In the case that the heating temperature is about 70°C and over, the masking solution (masking agent) is imparted with sufficient fluidity and is locally spread to decrease and reduce the pores (gaps) between inks. The heating temperature of the substrate (surface temperature of the substrate) coated with the masking solution is more preferably about 75-105°C and is more preferably about 78-103°C. Particularly preferably, the substrate is heated to from the melting point of the paraffin constituting the masking agent to the melting point of the paraffin + 5°C and less. The heating time of the substrate is dependent on the heating temperature, however is preferably about 10 seconds and over to obtain sufficiently increasing effects of coating density. In addition, the upper limit of the heating time is not specifically limited, however is preferably about 15 seconds and less in consideration of the control of the shape and value of a target design.

An apparatus for heating the substrate coated with the masking agent is not specifically limited, and the substrate may be locally heated or heat-retained using a heating source, for example, an IR heater or a halogen heater.

The thickness of the mask pattern is not specifically limited and is preferably about 0.1-100 µm and is more preferably about 1-50 µm. If the thickness of the mask pattern is above the lower limit, the generation of pin holes may be restrained. Thus, the mask pattern may exhibit functions as a mask in a plating treating process, which will be described later. Meanwhile, if the thickness of the mask pattern is less than the upper limit, the deterioration of the adhesion of the mask pattern and the substrate or the generation of cracks due to the increase of internal stress may be restrained. In addition, in the case that the masking agent is coated by an inkjet method, the ink is preferably carbonized (coated) thick (to a multilayer) by dividing several times to decrease or prevent (to improve coating density) of the pores (gaps) between carbonized inks. In view of the above points, the thickness of the mask pattern is preferably about 10-100 µm and more preferably about 10-50 µm. The pores (gaps) between carbonized inks may be significantly decreased or prevented (the coating density may be improved) in the case that the masking solution is coated on a substrate and dried, and then, the substrate coated with the masking solution is heated as described above, in the case that the masking solution is coated on a heated or heat-retained substrate, or in the case that both cases are applied. In this case, defects of plating treating of the gaps of a carbonized masking agent may be prevented even though the mask pattern has an even smaller thickness. The thickness of about 0.1 µm and over is sufficient, and the thickness of about 1-20 µm is more preferable in consideration of the decrease of the amount of ink and coating time.

In addition, the width of the mask pattern is not specifically limited and is set according to the pattern formed. The width of the pattern formed may be increased to an optional width by connecting a plurality of inkjet heads.

The substrate is not specifically limited and may be a resin film such as a glass epoxy material, a polyimide film, a polyamide film, a polyester film, a polytetrafluoroethylene film, a polyphenylenesulfite film, polyethylenenaphthalate film, a liquid crystal polymer film, etc., a BT resin, a silicon wafer, glass, a liquid crystal film, aramide, ceramic, and a metal plate of copper, silver, tin, nickel, gold, etc. In addition, a product obtained by forming a conductive layer such as copper, silver, tin, nickel, gold, etc. on the substrate, for example, a metal thin film attached resin film obtained by forming a metal thin film on the surface of a resin film such as a polyimide film may be used as the substrate. The conductive layer may function as a metal wiring and may be provided on the whole surface of the substrate or formed as a pattern shape. The thickness of the conductive layer is not specifically limited. In this embodiment, a wiring board or an electronic part may be used as the substrate, and a metal pattern (metal layer) may be formed on the wiring board or the electronic part by plating. In addition, in the present disclosure, the term "wiring board" is a print wiring plate represented by a mother board, a package substrate represented by a central process unit (CPU), a chip set, a ceramic substrate, a touch panel substrate, etc. In addition, the term "electronic part" represents a semiconductor chip, connectors, sockets, etc. In addition, a wiring board provided with an electronic part is also included in the wiring board or the electronic part.

The shape of the substrate is not specifically limited, and may be a sheet shape, a plate shape, a roll shape, a hoop shape, etc. The roll shape may be obtained by attaching the sheet shape or the plate shape on a rotor (roll). The hoop shape may be obtained by installing rolls at from two to several places in the hoop and passing a conductive base having hoop shape through the rolls. All the roll shape and the hoop shape may produce surface treated base continuously, and producing efficiency is preferably high when compared to the sheet shape and the plate shape.

The thickness of the substrate is not specifically limited and is preferably in a range of about 5 µm to about 3 mm. In addition, in the case of including a conductive layer, the thickness is preferably in a range of about 5-20 µm. The temperature of the substrate during coating the masking is not specifically limited, however may be a surrounding temperature and may preferably be in a range of about 18-60°C. The temperature of the substrate during coating the masking means the temperature of the surface of the substrate (coating surface) for coating the masking solution. By controlling the temperature of the substrate during coating the masking to the above-described range, the degree of precision of the mask pattern may be improved. Particularly, in the case of using an inkjet method, the surface tension of the masking solution for carbonization may be limited, and the degree of precision of the patterning may be improved. More preferably, the temperature of the substrate is about 24-60°C for restraining the exfoliation of the masking solution (masking agent) due to rapid contraction.

In another preferable embodiment, the substrate is heated or heat-retained during coating masking. That is, in a preferred embodiment of the present invention, the process of forming the mask pattern includes a process of coating the masking solution on the substrate heated and heat-retained. According to the configuration, the ink diffusion of the coated masking solution (masking agent) may be improved, the pores (gaps) between carbonized inks may be decreased, reduced and further prevented, and the resolution of the mask pattern may be improved. Particularly, since the mask pattern of an edge part may become smooth, a smooth edge may be formed. In addition, the adhesiveness of the masking solution (masking agent) with the substrate may be improved. Generally, in the case that a hot melt ink is coated, the ink is preferably carbonized (coated) thick (to a multilayer) by dividing several times to decrease or prevent (to improve coating density) of the pores (gaps) between carbonized inks. However, according to the present invention, such a multi-coating process is not necessary because the pores (gaps) between inks may be decreased or prevented by a simple method of heating or heat-retaining the substrate for carbonizing using the masking agent. Thus, the amount used of the masking solution may be significantly decreased, and the coating treating time may be markedly decreased.

The temperature of the substrate heated or heat-retained is preferably about 40-50°C. If the temperature is about 50°C and less, the fluidity of the masking solution (masking agent) coated is too high, and the deterioration of the degree of precision of the pattern due to the collapse of the shape of the mask pattern may be prevented. If the temperature is about 40°C and over, the ink diffusion of the masking solution (masking agent) may be improved, and the pores (gaps) between inks may be decreased and reduced.

In addition, the term "heating" means positive application of heat in the present invention. Thus, the heating includes a case that heat is initially applied to the substrate to increase to a certain temperature and then is not applied, and a case that heat is applied to the substrate initially and after. Meanwhile, the term "heat-retaining" means difficulty in loosing heat, that is, difficulty in lowering the temperature.

An apparatus for heating the substrate during coating the masking is not specifically limited, and the substrate may be locally heated or hat-retained using a heating source, for example, an IR heater or a halogen heater or may be placed in a thermostat maintaining a constant temperature to use a substrate reaching thermal equilibrium (that is heated or heat-retained substrate).

### (3) Plating treating process (103 of FIG. 1)

Then, the substrate 21 provided with the mask pattern 22 formed in the above-described process is immersed in a plating solution as shown in (3) of FIG. 2 to form a metal layer 23 on the non-forming part of the mask pattern.

In addition, the substrate may be pre-treated in advance of the immersing in the plating solution to improve the adhesiveness of the substrate 21 and the metal layer 23, etc. The pre-treatment may include, for example, cleaning treatment such as blast treatment, alkaline washing, acid washing, washing, washing with an organic solvent, bombard treatment, etc., etching treatment, forming of a bottom layer, etc.

As the constituting materials of the metal layer, for example, Ni, Cu, Ag, Au, Cr, Zn, Sn, a Sn-Pb alloy, etc., may be included.

The thickness of the metal layer formed by the plating treatment is not specifically limited and is preferably about 0.5 µm and over for exhibiting sufficient conductivity. Meanwhile, the upper limit of the thickness is not specifically limited.

The plating treating method is not specifically limited, and for example, electroplating, electroless plating, etc., may be conducted.

Generally, the electroless plating includes three processes of (1) a hydrophilization process, (2) a catalyzation process and (3) an electroless plating process. The hydrophilization process may be omitted according to the kind of a substrate.

In the hydrophilization process (etching process), minute embossing is formed on the surface of the substrate using an oxidant such as chromic acid, a mixture of anhydrous chromic acid-sulfuric acid, permanganate, etc., a strong acid such as hydrochloric acid, sulfuric acid, fluoric acid, nitric acid, etc., a strong alkaline solution such as sodium hydroxide, potassium hydroxide, etc., and the adhesion of the substrate and the metal layer may be attained by the anchor effect of the embossing after electroless plating, which will be described later.

In the catalyzation process, a catalyst layer is formed as an anchoring point of electroless plating, which will be conducted on the surface of the substrate in a subsequent process. The method of forming a catalyst layer is not specifically limited, and commercially available catalyzation reagent for electroless plating may be used. For example, a method of precipitating palladium on the surface of a substrate by using a solution including palladium chloride and stannous chloride as a catalyzation reagent, immersing the substrate in the reagent to adsorb a catalyst metal onto the surface of the substrate, and reducing palladium ions using an acid such as sulfuric acid or hydrochloric acid or an alkaline solution such as sodium hydroxide (catalyst acceleration method), a method of precipitating palladium on the surface of a substrate by contacting a substrate with stannous chloride to adsorb stannous ions onto the surface of the substrate and immersing in a palladium solution, etc. may be used.

Then, the substrate is immersed in an electroless plating bath including a metal salt, a reducing agent, a carbonizing agent, etc., and electroless plating is conducted.

As the metal salt, salts of the above-described metals as the metal for constituting the metal layer may be illustrated. For example, in the case of using a nickel salt, nickel chloride, nickel sulfate, nickel acetate, etc., may be included. The concentration of the metal salt in the electroless plating bath may be appropriately set according to the size (surface area) of the substrate to form a metal layer with a desired thickness.

As the reducing agent, sodium hypophosphite, dimethylamine borane, sodium borohydride, potassium borohydride, hydrazine, etc., may be used.

As the carbonizing agent, for example, citric acid, hydroxyl acetic acid, tartaric acid, malic acid, sulfuric acid, gluconic acid, or a carboxylate such as an alkali metal salt thereof or an ammonium salt thereof, an amino acid such as glycine, amine acid such as ethylenediamine, alkylamine, etc., an ammonium compound, EDTA, pyrophosphate, etc., may be included. The carbonizing agent may be used solely or two or more thereof may be used together.

In the electroless plating method, pH of the electroless plating bath is preferably about 4-14.

In the electroless plating method, when a substrate is added, a reaction is carried out promptly while accompanying the generation of a hydrogen gas. In the electroless plating method, the termination of the electroless plating process may be judged by the time when the generation of the hydrogen gas is completely terminated. After completing the reaction, a plated material is taken out from a reaction system, and washing and drying are conducted as occasion demands.

The electroless plating process may be repeated may times. By conducting the processes, a plurality of metal layers may be coated on the substrate. For example, nickel plating is conducted on the substrate, and electroless gold plating is conducted to obtain a laminated shape of a nickel layer and a gold layer on the substrate.

Meanwhile, in the electroplating method, an object material to be plated as a part of a cathode is immersed in an aqueous solution or a non-aqueous solution in which a metal salt and a lubricant and a surfactant as occasion demands are dissolved as a plating solution, and a metal such as nickel, chromium, copper, etc. is precipitated on the object to be plated of the cathode from the plating solution by the electrolytic decomposition by flowing current using an electrode. Thus, the object to be plated is necessary to have conductivity when using the electroplating method, and for example, a product obtained by forming a conductive layer on a substrate as described above may be used as the object to be plated. As the metal salt, any metal salts constituting the metal layer may be used without specific limitation, and the concentration of the metal salt in the plating solution may be appropriately selected according to the size (surface area) of the substrate to form a metal layer to a desired thickness.

The temperature of the plating treatment is dependent on the kind of the plating solution and a plating method (electroplating, electroless plating).

Commonly, the temperature of the plating solution is about 40-80°C for the electroless plating and about 20-70°C and preferably about 50-65°C for the electroplating. In the case of using an alkaline, cyan solution, the temperature of electroplating treatment is about 50°C and over. In addition, the electroless plating treatment is conducted at about 50°C and over in many cases. In the present invention, the temperature is not specifically limited only if preventing the melting of the masking agent during plating treatment, and the temperature less than the melting point of paraffin constituting the masking agent may be applied. Preferably, the plating treatment is conducted at the temperature of the melting point of the paraffin -10°C and less. In a particularly preferable embodiment, the masking agent is formed using paraffin with a melting point of the temperature of plating treatment (temperature of plating solution) + 10°C to + 50°C, more preferably, the temperature of plating treatment (temperature of plating solution) + 10°C to + 30°C. That is, the plating treatment is particularly preferably conducted at the temperature of the melting point of paraffin - 10°C to - 50°C, more preferably, the temperature of the melting point of paraffin - 10°C to - 30°C.

The time of plating treatment is appropriately controlled according to the temperature of the plating treatment, the kind of the plating solution, etc. For example, the plating treatment is conducted at about 65°C for about 60 minutes. As the plating solution, a known plating solution, for example, a copper cyanide plating solution, a copper pyrophosphate plating solution, a copper sulfate plating solution, a nickel plating solution, a nickel sulfamate plating solution, a chromium plating solution, a zinc cyanide plating solution, a zinc no-cyan plating solution, an alkaline tin plating solution, an acidic tin plating solution, a tin plating solution, a gold cyanide plating solution, an acidic gold plating solution, etc. may be used.

### (4) Masking agent removing process (104 of FIG. 1)

Subsequently, the masking agent constituting the mask pattern obtained in the above processes is removed by a refrigerant with a temperature less than the melting point of the paraffin. Then, a surface treated base 24 obtained by forming the metal layer 23 with a pattern shape on the substrate 21 is formed as shown in (4) of FIG. 2. Since the paraffin has high contraction percentage during cooling, the mask pattern including the paraffin may be easily exfoliated from the substrate by cooling the mask pattern to a temperature less than the melting point of the paraffin. The masking agent (masking pattern) of this shape may realize the excellent adhesion and exfoliation property of the mask pattern by controlling the coating temperature of the masking agent, the temperature of plating treatment and the removing temperature of the masking agent. Thus, good adhesion and exfoliation property and improved degree of precision of plating finishing may be attained when compared to a masking tape used in a common plating treatment.

As the refrigerant, a medium of liquid or gas having a temperature less than the melting point of the paraffin may be used. As the liquid, any one of acidic, alkaline and neutral medium may be used. In the case of using the acidic and alkaline medium, adverse effects of discoloration of a metal layer (metal pattern) formed by surface treatment such as plating, may be shown. Thus, in the case of using the liquid, the neutral medium is preferable. That is, the refrigerant is preferably cold air and/or a neutral liquid. More preferably, the neutral liquid is used. Commonly, a washing apparatus for washing the substrate after plating is attached to a plating apparatus. In the case of using a neutral liquid, a common washing apparatus may be used for removing a masking agent. Thus, a novel apparatus/equipment for removing the masking agent is not necessary. Further, the removing of the masking agent may be conducted together with the washing of the substrate, and the conditions are favorable in consideration of a producing process.

The cold air may be cooled gas of the air, nitrogen, carbon dioxide, etc.

As the neutral liquid, any neutral liquid not dissolving the paraffin may be used without specific limitation and a known material may be appropriately selected and used in line with the paraffin used. For example, water, a ketone solvent such as methyl ethyl ketone, acetone, diethyl ketone, methyl isobutyl ketone, methyl isopropyl ketone, cyclohexanone, 3-heptanone, 4-heptanone, etc., an alcohol solvent such as methanol, ethanol, n-propanol, isopropanol, n-butanol, i-butanol, t-butanol, 3-methyl-1-butanol, 1-pentanol, 2-pentanol, n-hexanol, cyclohexanol, 1-heptanol, 1-octanol, 2-octanol, 2-methoxyethanol, allyl alcohol, furfuryl alcohol, phenol, etc., brine (aqueous sodium chloride solution), etc. may be used. Among them, water is preferable. Water may be appropriately selected from pure water, tap water, underground water, distilled water, ion exchanged water, etc. Among them, the pure water is preferably used in consideration of the prevention of the introduction of impurities and the prevention of the deterioration of the purity of a masking agent recovered from a recovering process of the masking agent, which will be described later. In addition, the above-described material may be used solely or as a mixture of two or more.

In the present disclosure, neutral corresponds to the pH range of about 5-9, preferably pH of about 6-8 and more preferably, pH of about 6-7. By using the neutral liquid, adverse effects with respect to a metal layer due to immersion in an alkaline solution, etc. may be prevented.

The temperature of the refrigerant is not specifically limited only if the temperature is less than the melting point of the paraffin and the paraffin is exfoliated due to the contraction thereof. The contraction percentage of the paraffin depends on the melting point of the paraffin and may be appropriately set according to the melting point of the paraffin used in the masking agent. Particularly, the temperature of the refrigerant is preferably about (the temperature of paraffin - 60)°C and less, more preferably about (the temperature of paraffin - 70)°C and less, and more preferably, about (the temperature of paraffin - 80)°C and less for obtaining good exfoliation. In an embodiment, the temperature of the refrigerant is preferably about 25°C and less, more preferably, about 10°C and less, and more preferably, about 5°C and less for simplicity, and particularly preferably, about 0°C and less for decreasing exfoliation time. The lower limit of the temperature of the refrigerant is not specifically limited. For example, in the case of using liquid nitrogen, the temperature may be about -196°C.

The removal using the refrigerant may be conducted under an atmospheric pressure, pressurized conditions, reduced pressure, without specific limitation. Preferably, the removal is preferably conducted under an atmospheric pressure or ± 5% thereof, and more preferably ± 1% thereof (in a range of common atmospheric change).

A method of removing the masking agent constituting the mask pattern using the refrigerant is not specifically limited, and in the case of using cold air, for example, a method of applying cold air on the surface of the mask pattern may be used. In addition, in the case of using a liquid, a method of spraying or taking shower of the refrigerant on the mask pattern, a method of immersing a substrate with a mask pattern formed thereon in the liquid, etc. may be used. These methods may be used together and may be repeated many times. Preferably, the method of immersing the substrate with the mask pattern in a neutral liquid is used. In addition, in the case of using the cold air and the neutral liquid together, a method of applying cold air first and spraying/taking shower using neutral liquid or immersing in a neutral liquid is preferable.

In the case of applying the cold air, preferable applying rate is about 200-800 m/s, and applying time is dependent on the temperature of the cold air or the applying rate and is preferably from about 5 seconds to about 1 minute.

In the case of immersing the substrate in a liquid, immersing time may be changed according to the temperature of the liquid, and is preferably from about 30 seconds to about 50 minutes and more preferably, from about 5 minutes to about 30 minutes. In addition, ultrasonic vibration may be applied during immersion as occasion demands. Pure water/distilled water may be used for more accurate exfoliation.

In the case of spraying/taking shower of the liquid, time for spraying/taking shower is appropriately set according to the temperature of the liquid.

In addition, the masking agent may be removed by the refrigerant with the temperature less than the melting point of the paraffin after cooling the mask pattern in a process of removing the masking agent by the refrigerant to further improve the exfoliation property of the masking agent in a method of an embodiment. The cooling method of the mask pattern is not specifically limited, and air cooling, water cooling, etc. may be conducted.

### (5) Masking agent recovering process (105 of FIG. 1)

Then, the masking agent removed by the refrigerant is recovered as occasion demands. The masking agent removed after plating treatment may be discarded, or the removed masking agent may be recovered for decreasing the burden on the environment. Preferably, the recovered masking agent is reused.

The recovering method of the masking agent is not specifically limited, for example, a method of precipitating or floating the removed masking agent in a liquid (recovering liquid) and then recovering may be used. The masking agent cooled by the refrigerant and removed is a lump of a solid state. Thus, the solid of the masking agent of a lump state may be easily recovered through precipitation or floating.

As the usable liquid (recovering liquid), any one not dissolving the masking agent may be used without specific limitation.

Preferably, the recovering process includes recovering of the removed masking agent by floating in a neutral liquid having higher specific gravity than the masking agent. In this case, since the masking agent exfoliated from the substrate due to the cooling and contraction is floating in the neutral liquid, the recovering of the masking agent, which will be described layer, may be simply conducted. More preferably, water, particularly preferably, pure water is used as the recovering liquid. In this case, the injection of impurities into the recovered masking agent may be prevented, and the deterioration of the purity of the recovered masking agent may be prevented. For example, the density of the paraffin is commonly about 0.85-0.89 g/cm3 at about 20°C, and the specific gravity thereof is smaller than water. Thus, the masking agent may be simply and cheaply recovered using water as the recovering liquid. Further, the discard of water after use is easy, and water is preferable in consideration of environmental conservation.

In addition, in the case of conducting the removing of the masking agent using the neutral liquid, the neutral liquid for removing the masking agent (removing liquid) and the recovering liquid for recovering the masking agent may be the same or different. Preferably, the removing liquid and the recovering liquid are the same in consideration of the price and the simplicity of a producing process. More preferably, the removing of the masking agent in a previous process is conducted by immersing a substrate with a mask pattern in a neutral liquid, and the masking agent constituting the mask pattern precipitated or floating in the neutral liquid after the process is recovered. In this case, the removing of the mask pattern and the recovering of the masking agent may be conducted using the same neutral liquid. Particularly preferably, a neutral liquid having greater specific gravity than the masking agent is used as the removing liquid and the recovering liquid. Preferably, the neutral liquid is water, and specifically preferably, pure water.

The temperature of the recovering liquid is not specifically limited only if less than the melting point of the paraffin. Preferably, the temperature is about 25°C and less, more preferably, about 10°C and less, and more preferably, about 5°C and less for simplicity, and particularly preferably, about 0°C and less for decreasing exfoliation time. Meanwhile, the lower limit of the temperature of the recovering liquid is not specifically limited.

The recovered masking agent may be reused for the preparation of a masking solution. That is, the recovered masking agent is heated to a temperature higher than the melting point to prepare the masking solution. Otherwise, the masking solution may be reused after removing the impurities in the recovered masking agent, for example, metal pieces, metal particles, garbage/dust, etc. produced by plating treatment, etc. Thus, the method for producing a surface treated base using the masking agent is a simple and cheap method and is an innovative method capable of decreasing or eliminating waste materials such as a common masking tape because the masking agent may be substantially and completely reused. However, the recovered masking agent may be reused after separation as occasion demands.

### [Second embodiment]

In an embodiment of the present invention, the surface treatment is an etching treatment. That is, according to an embodiment of the present invention, a method for producing a surface treated base including a process of preparing a substrate with a metal layer formed on the surface thereof (substrate preparing process), a process of preparing a masking solution by heating a masking agent including paraffin to a temperature more than the melting point of the paraffin (masking solution preparing process), a process of patterning the masking solution on the metal layer to form a mask pattern (masking solution patterning process), a process of etching the substrate having the mask pattern (etching process) and a process of removing the masking agent constituting the mask pattern using a refrigerant having a temperature less than the melting point of the paraffin (masking agent removing process), is provided.

The masking agent may be used for forming a mask pattern for an etching treatment. In an etching treatment using a common dry film resist, the reuse of the waste material of a dry film used after the etching treatment is difficult and has defects of having great burden on the environment. In addition, in the etching treatment, an aqueous alkaline solution used for removing a cured resist layer after etching has defects of inducing adverse effects such as the discoloration of a metal pattern, etc.

In contrast, the masking agent may be easily removed, recovered and reused after plating using a non-alkaline refrigerant. Thus, etching treatment inducing no adverse effects on the pattern formed and having little environmental burden is possible.

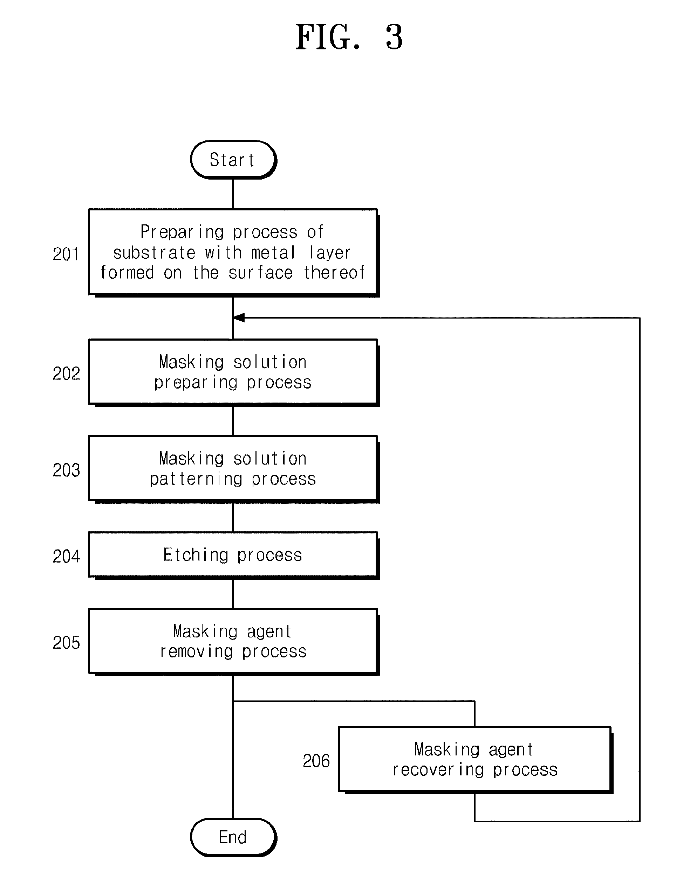

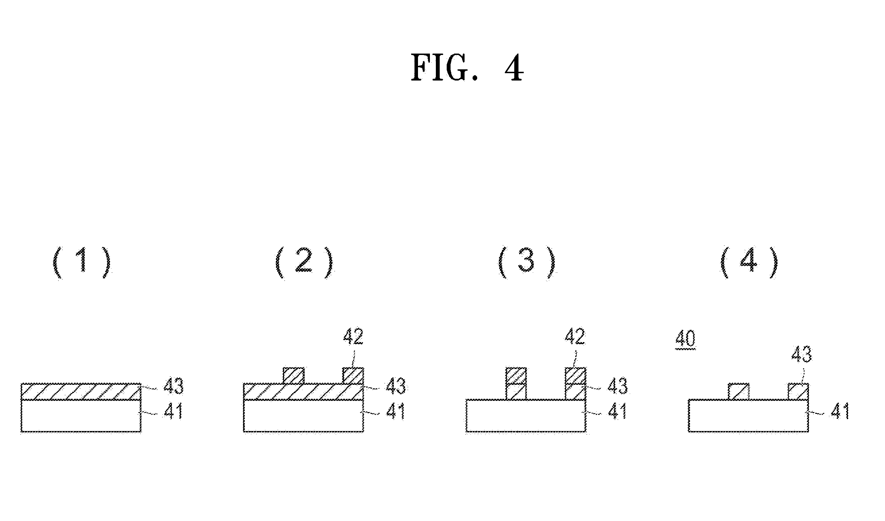

Hereinafter, each process constituting the producing method according to an embodiment will be explained referring to FIGS. 3 and 4.

### (1) Substrate preparing process (201 of FIG. 3)

First, a substrate 41 with a metal layer 43 formed thereon as shown in (1) of FIG. 4 is prepared.

A substrate 41 is not specifically limited, and preferably includes the examples illustrated as the substrate 21 in an embodiment on the method for producing the surface treated base by the plating treatment. The thickness of the substrate is not specifically limited and is preferably in a range from about 5 µm to about 10 mm.

The constituting material of a metal layer 43 is not specifically limited and may include, for example, Ni, Cu, Ag, Au, Cr, Zn, Sn, a Sn-Pb alloy, etc. The thickness of the metal layer is not specifically limited and is preferably about 0.5 µm and over for exhibiting sufficient conductivity. In addition, the upper limit is not limited.

The metal layer may be formed by a (vacuum) deposition method, a sputtering method, a CVD method, a magnetron sputtering method, a plating method, a cluster-ion beam method, an ion plating method, etc. Any methods may be used, however the magnetron sputtering method is generally used in industry in consideration of high producing efficiency. Alternatively, a substrate on which a metal layer is formed in advance, for example, a wiring board such as a metalized resin metal thin film attached resin film or an electronic part, may be used.

In addition, etching of a metal plate itself may be conducted using a substrate formed using a metal plate instead of the substrate 41 on which the metal layer 43 is formed. As the metal plate, examples of the metal plate of the substrate 21 may be used.

### (2) Masking solution preparing process (202 of FIG. 3)

Subsequently, a masking solution is prepared. The preparation method of the masking solution is the same as the method according to an embodiment concerning the method for producing the surface treated base by plating treatment, and particular explanation thereon will be omitted.

### (3) Masking solution patterning process (203 of FIG. 3)

Then, as shown in (2) of FIG. 4, the masking solution is patterned on the metal layer 43 to form a mask pattern 42. Particular patterning method of the masking solution is the same as the method according to an embodiment concerning the method for producing the surface treated base by plating treatment, and particular explanation thereon except for patterning the masking solution on the metal layer 43 instead of the substrate 21 will be omitted.

In addition, in the case of heating or heat-retaining the substrate during coating the masking, the coating surface for coating the masking solution, that is, the surface of the metal layer 43 is preferably heated or heat-retained to the above temperature. In addition, in the case of heating the substrate coated with the masking solution after coating the masking solution on the substrate and drying, the coating surface of the masking solution, that is, the surface of the metal layer 43 is preferably heated or heat-retained to the above temperature.

### (4) Etching process (204 of FIG. 3)

Then, the substrate 41 having the mask pattern 42 is etched as shown in (3) of FIG. 4.

The etching method is not specifically limited, and a method of immersing a substrate having a mask pattern in an etching solution, a method of spraying an etching solution, etc. may be used. The etching solution is determined according to the kind of the metal layer for etching, and an acid etching solution having diverse compositions, an alkaline etching solution, a copper ammonium solution, a ferric chloride solution, a cupric chloride solution, etc. may be used.

As the acid etching solution, a general aqueous acid solution including at least one of sulfuric acid, hydrochloric acid, fluoric acid, phosphoric acid, nitric acid, an organic acid, etc. may be used. Among them, an acid aqueous solution including the sulfuric acid or the hydrochloric acid is preferable, and particularly preferably, the sulfuric acid and the hydrochloric acid are used together. In the case of using the sulfuric acid and the hydrochloric acid together, the ratio of the sulfuric acid with respect to the total etching solution is preferably in a range of about 1-50 wt% in consideration of etching rate, is more preferably in a range of about 3-30 wt%, and is particularly preferably in a range of about 12.5-20 wt%. The ratio of the hydrochloric acid with respect to the total etching solution is preferably in a range of about 0.1-20 wt% in consideration of etching rate, is more preferably in a range of about 0.5-15 wt%, and is particularly preferably in a range of about 7-10 wt%.

The alkaline etching solution is not specifically limited and may use a general alkaline aqueous solution such as lithium hydroxide, potassium hydroxide, sodium hydroxide, ammonia, tetramethylammonium hydroxide, choline, or a mixture thereof with hydrogen peroxide. Particularly, an aqueous sodium hydroxide solution or aqueous ammonium solution is used, and the concentration is preferably about 40 wt% and over, and more preferably about 45 wt% and over. To increase the concentration further, water may be evaporated from the aqueous alkaline solution.

The etching solution may be easily prepared by dissolving each of the above components in water. As the water, water from which ionic materials or impurities are removed, such as ion exchanged water, pure water, etc. is preferably used.

The temperature of the etching solution is not specifically limited only if capable of preventing the melting of the masking agent during etching treatment, and the temperature may be less than the melting point of the paraffin constituting the masking agent. Preferably, the etching treatment is conducted at the temperature of the melting point of paraffin -10°C and less. Meanwhile, the lower limit is not specifically limited and is preferably about 25°C and over. Particularly preferably, the etching treatment is conducted at the temperature of the melting point of the paraffin constituting the masking agent - 10°C to - 50°C, and more preferably at the temperature of the melting point of the paraffin constituting the masking agent - 10°C to - 30°C.

In the etching solution, other components may be further mixed appropriately. As other components, for example, a surfactant for improving wetting property with respect to a metal layer, a defoaming agent for restraining the formation of bubbles during etching by a spray method, an anti-rust additive for preventing the discoloration of copper, etc. may be used.

The time of the etching treatment is appropriately controlled according to the kind of the etching solution, the temperature or the spraying pressure of the etching solution, etc. In an embodiment, the etching treatment is commonly conducted using an etching solution at about 50°C for about 1 minute.

### (5) Masking agent removing process (205 of FIG. 3)

Then, the masking agent constituting the mask pattern 42 is removed using a refrigerant having a temperature less than the melting point of the paraffin. Thus, a surface treated base 44 obtained by forming the metal layer 43 having a pattern shape on the substrate 41 is formed. Since the removing process of the masking agent is the same as the method in an embodiment concerning a method for producing a surface treated base by the plating treatment, particular explanation thereof will be omitted.

### (6) Masking agent recovering process (206 of FIG. 3)

Then, the masking agent removed by the refrigerant is recovered as occasion demands. The recovered masking agent may be reused as in an embodiment concerning the method for producing the surface treated base by the plating treatment. Since the particular method of the recovering process is the same as the method in an embodiment concerning the method for producing a surface treated base by the plating treatment, particular explanation thereof will be omitted.

### [Other embodiments]

In the present invention, the surface treatment such as the plating treatment or the etching treatment may be repeated many times, and/or the plural surface treatments such as the plating treatment and the etching treatment may be combined to form a laminated pattern.

For example, a method of conducting a plating treating process, selectively pattering a masking solution on the surface of a metal layer formed on a substrate, plate treating again, and removing the masking agent, a method of conducting plating treatment and removing a masking agent, selectively patterning a metal layer formed on the substrate and/or the surface of the substrate, plating treating again and removing the masking agent, a method of conducting etching treating, selectively patterning a masking solution on the surface of the non-forming part of the masking agent of the substrate, plating treating again and removing the masking agent, a method of conducting etching treatment and removing a masking agent, selectively patterning a masking solution on the substrate and/or on the surface of a metal layer, etching treating again and removing the masking agent, a method of conducting plating treating, removing a masking agent as occasion demands, selectively patterning a masking solution on the surface of a metal layer formed on the substrate, and removing the masking agent, a method of conducting etching treating, removing a masking agent as occasion demands, selectively patterning a masking solution on the substrate and/or on the surface of a metal layer and plating treating, may be conducted.

### [Separate embodiments]

The present invention also provides a coating apparatus, a removing apparatus, a coating removing system, a coating method, a removing method and a coating removing method. Particularly, the present invention also includes the following embodiments described in (1) to (32).
(1) A coating apparatus for coating a hot melt coating material which is a solid at room temperature and is liquefied by heating, only on a non-treating surface among an object to be treated including a treating surface and a non-treating surface by surface treatment, and the coating apparatus includes an inkjet part discharging the molten coating material toward the object to be treated, a supplying part for supplying the molten coating material to the inkjet part and a heating apparatus provided at the supplying part for melting the coating material. According to an embodiment described in the above (1), the coating material molten by the heating apparatus is discharged by the inkjet part and coated on the non-treating surface of the object to be coated, and masking may be formed on a complicated and small non-treating surface.
(2) The coating apparatus described in the above (1), in which the supplying part includes a tank part for injecting the coating material in a solid state or a liquid state, a connecting part for connecting the inkjet part and the tank part, and a delivering part for delivering the molten coating material in the tank part via the connecting part to the inkjet part, and the heating apparatus includes a first heating part provided at the tank part for melting the coating material and a second heating part provided at the connecting part for maintaining the molten state of the coating material. According to an embodiment described in the above (2), the coating material of a solid phase is placed in the tank part, workability may be improved.
(3) The coating apparatus described in the above (2), in which the delivering part includes a natural flowing apparatus for flowing the molten coating material from a high place by disposed the tank part at the upper portion of the inkjet part, or a pumping apparatus. According to an embodiment described in the above (3), the coating material is delivered from the tank part to the inkjet part, and workability may be improved.
(4) The coating apparatus described in any one of (1) to (3) further including a control part for relatively moving the inkjet part three dimensionally with respect to the object to be coated and controlling the coated position of the coating material freely in the object to be coated by controlling the position of the inkjet part. According to an embodiment described in the above (4), an object to be coated even having a three dimensional shape may be coated with the coating material.
(5) The coating apparatus described in the above (4), in which the control part includes a first rotationally moving part and a second rotationally moving part for rotating the inkjet part with respect to the object to be coated and for giving a slope with respect to a carbonization surface around axes of a first direction and a second direction perpendicular to each other at the carbonization surface where the coating material of the object to be coated is carbonized. According to an embodiment described in the above (5), an object to be coated even having a three dimensional shape may be coated with the coating material.
(6) The coating apparatus described in the above (5), in which the row of inkjet nozzles provided at the inkjet part is arranged in the second direction, the coating material is discharged one by one by the inkjet part along the first direction, and the control part further includes a third rotationally moving part for relatively rotating the inkjet part with respect to the object to be coated for giving a slope to the row of the inkjet nozzles with respect to the second direction around an axis in a third direction perpendicular to the carbonization surface. According to an embodiment described in the above (6), the density of the component of the second direction of the carbonized coating material may be increased, and defects of plating treatment may be prevented.
(7) The coating apparatus described in any one of (1) to (6) further including another inkjet part for discharging the coating material in a different direction from the discharging direction of the coating material from the inkjet part. According to an embodiment described in the above (7), an object to be coated even having a three dimensional shape may be coated with the coating material.
(8) The coating apparatus described in any one of (1) to (7), in which the coating material is a masking agent including paraffin. According to an embodiment described in the above (8), the ink flowing of the carbonized coating material on the carbonization surface may be decreased.
(9) The coating apparatus described in the above (8), in which viscosity at about 80°C is about 5-30 mPa·s. According to an embodiment described in the above (9), the coating material may be discharged by the inkjet part, and the ink flowing of the carbonized coating material on the carbonization surface may be decreased.
(10) The coating apparatus described in the above (8) or (9), in which the amount of the paraffin is from about 85 wt% to about 100 wt% with respect to the total amount of the masking agent. According to an embodiment described in the above (10), chemical-resistance may be sufficiently exhibited.
(11) The coating apparatus described in any one of (1) to (10) further including a returning part for relatively returning the inkjet part and the object to be coated and a temperature controlling part provided at the returning part for controlling the temperature of the object to be coated. According to an embodiment described in the above (11), the ink flowing of the carbonized masking agent on the carbonization surface may be decreased, and the inkjet part and the object to be coated may be relatively easily returned.
(12) A removing apparatus including a cooling removing part for removing a coating material which is a masking agent including paraffin having a hot melt property of being liquefied by heating, and which is coated only on a non-treating surface of an object to be coated including a treating surface for surface treating and a non-treating surface for not conducting surface treating, as a solid state using a refrigerant at a temperature less than the melting point of the paraffin. According to an embodiment described in the above (12), the masking agent including the paraffin coated on the non-treating surface is removed from the object to be coated as a solid state using a refrigerant at a temperature less than the melting point of the paraffin, and the masking agent may be easily removed.
(13) The removing apparatus described in the above (12) including a recovering part at cooling side for recovering the masking agent of a solid state removed by the cooling removing part from the refrigerant to reuse the masking agent recovered at the recovering part at cooling side as the coating material described in any one of (1) to (11). According to an embodiment described in the above (13), the masking agent removed by the cooling removing part is reused, and the amount used of the coating material may be decreased.
(14) A removing apparatus including a cooling removing part for removing a coating material which is a masking agent including paraffin, which is a solid at room temperature and is liquefied by heating and coated only on a non-treating surface of an object to be coated including a treating surface for surface treating and a non-treating surface for not conducting surface treating, from the object to be coated as a solid state using a refrigerant having a temperature less than the melting point of the paraffin and a melting removing part for removing the coating material remaining at the non-treating surface after removing by the cooling removing part from the object to be coated by melting the coating material in a liquid having a temperature more than the melting point of the paraffin to make a liquid state. According to an embodiment described in the above (14), the masking agent including the paraffin coated on the non-treating surface is removed from the object to be coated as a solid state using a refrigerant having a temperature less than the melting point of the paraffin and the masking agent remaining at the non-treating surface is removed by making a liquid state by melting using a liquid having a temperature more than the melting point of the paraffin. Thus, the masking agent may be definitely removed.
(15) The coating apparatus described in the above (14) including a recovering part at cooling side for recovering the masking agent in a solid state removed by the cooling removing part from the refrigerant and a removing part at melting side for recovering the masking agent in a liquid state removed by the melting removing part after making the masking agent in a solid state to reuse the masking agent recovered by the recovering part at cooling side and the recovering part at melting side as the coating material described in any one of (1) to (11). According to an embodiment described in the above (15), since the masking agent removed by the cooling removing part and the masking agent removed by the melting removing part is reused, the amount used of the coating material may be decreased.
(16) A removing apparatus including a melting removing part for removing the coating material as the masking agent including paraffin which is a solid at room temperature and has a hot melt property of being liquefied by heat and coated only on a non-treating surface among a treating surface for surface treating and a non-treating surface for not conducting surface treating from an object to be coated by melting in a liquid having a temperature more than the melting temperature of the paraffin to make a liquid state. According to an embodiment described in the above (16), the masking agent including the paraffin and coated on the non-treating surface is removed by melting using a liquid having a temperature more than the melting point of the paraffin and making a liquid state from the object to be coated, and the masking agent may be easily removed.
(17) The removing apparatus described in the above (16) including a recovering part at melting side for recovering the masking agent in a liquid state removed by the melting removing part after making the masking agent in a solid state to reuse the masking agent recovered by the recovering part at melting side as the coating material described in any one of (1) to (11). According to an embodiment described in the above (17), the masking agent removed by the melting removing part may be reused, and the amount used of the coating material may be decreased.
(18) A coating removing system equipped with the coating apparatus described in any one of (1) to (11) and the removing apparatus described in any one of (12) to (17). According to an embodiment described in the above (18), the surface treatment may be easily conducted with respect to a minute region with high degree of precision.
(19) A coating method for coating a hot melt coating material which is a solid at room temperature and liquefied by heating on only a non-treating surface among an object to be coated including a treating surface for surface treating and a non-treating surface for not conducting surface treating, including a supplying process for supplying the molten coating material to an inkjet part and a discharging process for discharging the supplied coating material during the supplying process by the inkjet part. According to an embodiment described in the above (19), a masking may be formed on a complicated and minute non-treating surface because the molten coating material is supplied to the inkjet part and the supplied coated material is discharged by the inkjet part.
(20) The coating method described in the above (19), in which the supplying process includes an injecting process for injecting the coating material in a solid shape or a liquid shape into a tank part, a melting process for melting the coating material having the solid state and injected in the injecting process, a delivering process for delivering the coating material molten in the melting process to the inkjet part, and a melting maintaining process for maintaining the melting state of the coating material in a connecting part for connecting the tank part and the inkjet part. According to an embodiment described in the above (20), the coating material of a solid shape may be placed in the tank part, and workability may be improved.
(21) The coating method described in the above (19) or (20) further including a controlling process for relatively moving the inkjet part three-dimensionally with respect to the object to be coated and controlling the position of the inkjet part before conducting the discharging process and controlling the position to be coated of the coating material on the object to be coated. According to an embodiment described in the above (21), the coating material may be coated even though the object to be coated has a three-dimensional shape.
(22) The coating method described in any one of (19) to (21), in which the coating material is a masking agent including paraffin. According to an embodiment described in the above (22), the ink flowing of the coating material carbonized on a carbonization surface may be decreased.
(23) The coating method described in the above (22), in which the viscosity of the coating material at about 80°C is about 5-30 mPa·s. According to an embodiment described in the above (23), the coating material may be discharged by the inkjet part, and the ink flowing of the coating material carbonized on the carbonization surface may be decreased.
(24) The coating method described in the above (22) or (23), in which the amount of the paraffin is from about 85 wt% to about 100 wt% with respect to the total amount of the masking agent. According to an embodiment described in the above (24), chemical-resistance may be sufficiently exhibited.
(25) The coating method described in any one of (19) to (24) further including a returning process for relatively returning the inkjet part and the object to be coated of which temperature is controlled. According to an embodiment described in the above (25), the ink flowing of the masking agent carbonized on the carbonization surface may be decreased, and the inkjet part and the object to be coated may be easily and relatively returned.
(26) A removing method including a removing process for removing the coating material as the masking agent including paraffin, which is a solid at room temperature and has a hot melt property of being liquefied by heat and coated only on a non-treating surface among an object to be coated including a treating surface for surface treating and a non-treating surface for not conducting surface treating from an object to be coated in a solid state by a refrigerant having a temperature less than the melting point of the paraffin. According to an embodiment described in the above (26), the masking agent including the paraffin coated on the non-treating surface is removed by a refrigerant having a temperature less than the melting point of the paraffin in a solid state from the object to be coated, and the masking agent may be easily removed.
(27) The removing method described in the above (26) further including a recovering process at cooling side for recovering the masking agent in a solid state removed in the cooling removing process from the refrigerant to reuse the masking agent recovered in the recovering process at cooling side as the coating material described in any one of (19) to (25). According to an embodiment described in the above (27), the masking agent removed in the cooling removing process is reused, and the amount used of the coating material may be decreased.
(28) A removing method including a cooling removing process for removing the coating material as the masking agent including paraffin, which is a solid at room temperature and has a hot melt property of being liquefied by heat and coated only on a non-treating surface among an object to be coated including a treating surface for surface treating and a non-treating surface for not conducting surface treating as a solid state from an object to be coated using a refrigerant having a temperature less than the melting point of the paraffin, and a melting removing process for removing the coating material remaining on the non-treating surface after conducting the cooling removing process by melting in a liquid having a temperature more than the melting point of the paraffin and making a liquid state from the object to be coated. According to an embodiment described in the above (28), the masking agent including the paraffin coated on the non-treating surface is removed by a refrigerant having a temperature less than the melting point of the paraffin in a solid state from the object to be coated, and the masking agent remaining on the non-treating surface is removed by melting in the liquid having a temperature more than the melting point of the paraffin and making in a liquid state from the object to be coated. Thus, the masking agent may be more definitely removed.
(29) The removing method described in the above (28) further including a recovering process at cooling side for recovering the masking agent in a solid state removed in the cooling removing process from the refrigerant and a recovering process at melting side for recovering the masking agent in a liquid state removed in the melting removing process after making it in a solid state to reuse the masking agent recovered in the recovering process at cooling side and the recovering process at melting side as the coating material described in any one of (19) to (25). According to an embodiment described in the above (29), the masking agent removed in the cooling removing process and the masking agent removed in the melting removing process are reused, and the amount used of the coating material may be decreased.
(30) A removing method including a melting removing process for removing the coating material as the masking agent including paraffin, which is a solid at room temperature and has a hot melt property of being liquefied by heat and coated only on a non-treating surface among an object to be coated including a treating surface for surface treating and a non-treating surface for not conducting surface treating by melting in a liquid having a temperature more than the melting point of the paraffin and making a liquid state from an object to be coated. According to an embodiment described in the above (30), the masking agent may be easily removed from the object to be coated because the masking agent including the paraffin coated on the non-treating surface is melted in the liquid having a temperature more than the melting point of the paraffin to make it in a liquid state.
(31) The removing method described in the above (30) further including a recovering process at melting side for recovering the masking agent in a liquid state removed in the melting removing process after making it in a solid state to reuse the masking agent recovered by the recovering process at melting side as the coating material described in any one of (19) to (25). According to an embodiment described in the above (31), the masking agent removed in the melting removing process is reused, and the amount used of the coating material may be decreased.
(32) A coating removing method including the coating method described in any one of (19) to (25) and the removing method described in any one of (26) to (31). According to an embodiment described in the above (32), surface treatment may be easily conducted with respect to a minute region with high degree of precision.

Hereinafter, other embodiments will be explained in detail by dividing into Embodiments A to C.

### (Embodiment A)

Hereinafter, Embodiment A of the present invention will be explained referring to drawings. In addition, the numerical ratios in the drawings are exaggerated for convenience of explanation and may be different from practical ratios.

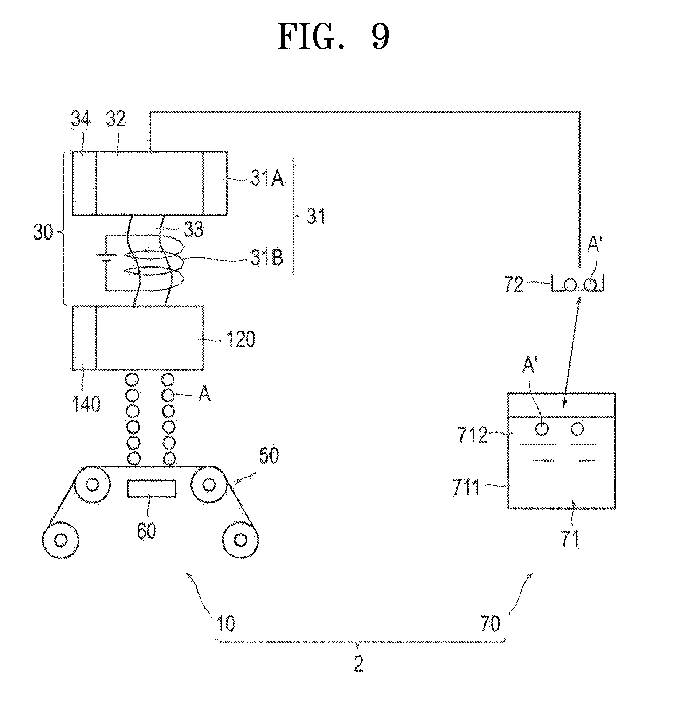

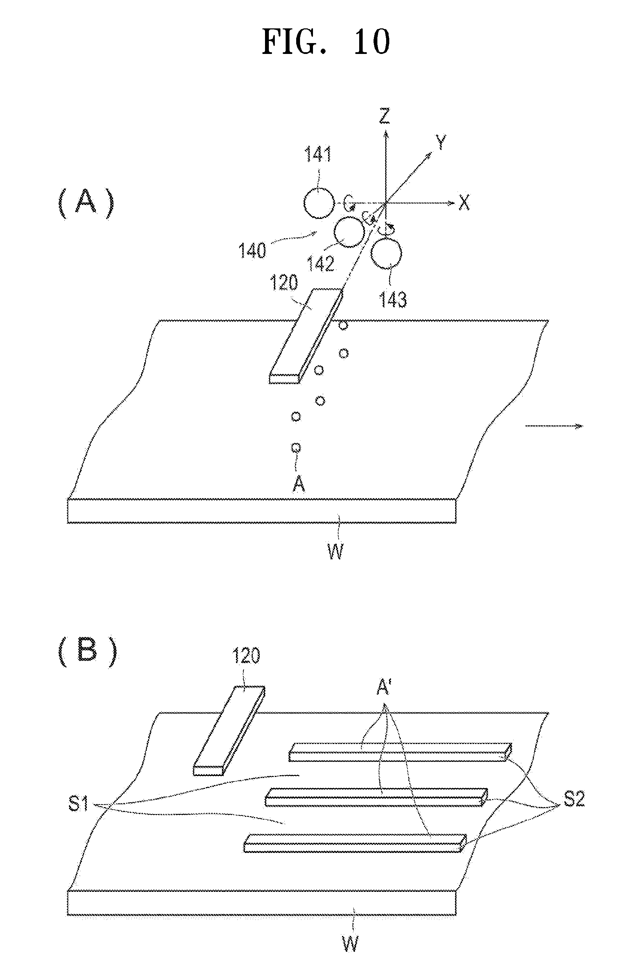

FIG. 9 is a drawing illustrating a coating removing system 2 concerning Embodiment A of the present invention. FIG. 10(A) is a drawing illustrating the coating state of the coating material A on the non-treating surface S2 of an object to be coated W by the inkjet part 120 of a coating apparatus 10 according to Embodiment A, and FIG. 10(B) is a drawing illustrating the state of the object to be coated W after coating. In addition, in FIG. 10, a direction of returning the object to be coated W is defined as an X-direction (first direction), a direction for arranging the row of inkjet nozzles 124 is defined as a Y-direction (second direction) and a direction perpendicular to the X-direction and the Y-direction is defined as a Z-direction (third direction).

As shown in FIG. 9, the coating removing system 2 includes a coating apparatus 10 and a removing apparatus 70.

### (Coating apparatus 10)

As shown in FIG. 10(A), a coating apparatus 10 is a coating apparatus 10 for coating the hot melt coating material A which is a solid state at room temperature and is liquefied by heating only on a non-treating surface S2 of an object to be coated W including a treating surface S1 for surface treating and a non-treating surface for not conducting surface treating. The treating surface S1 and the non-treating surface S2 constitute a carbonization surface S.

The coating apparatus 10 includes an inkjet part 120 for discharging the molten coating material A toward the object to be coated W and a heating apparatus 31 provided at a supplying part 30 for melting the coating material A.

The surface treatment means the modification of the surface of an object to be coated W by a chemical or physical method, and a chemical modification method such as plating, etching, electroforming, surface roughening, etc. and a physical modification method such as polishing, sputtering, etc. may be used.

The coating material A in this embodiment is a masking agent A' including paraffin. The coating material A is formed including the paraffin and a colorant and other additives as occasion demands. Particular components of the coating material A will be described later. The term "coating material A" is used before being coated on the object to be coated W, and after coating on the object to be coated W, the term "masking agent A"' is used.

The object to be coated W is, for example, a wiring board or an electronic part. The wiring board includes a print wiring plate represented by a mother board, a CPU, a chip set, a ceramic substrate, a package substrate represented by a touch panel substrate, etc. In addition, the electronic part includes a semiconductor chip, connectors, sockets, etc. The wiring board or the electronic part is formed using a glass epoxy material, a resin film such as a polyimide film, a polyamide film, a polyester film, a polytetrafluoroethylene film, a polyphenylenesulfite film, a polyethylenenaphthalate film, a liquid crystal polymer film, etc., a BT resin, a silicon wafer, glass, a liquid crystal film, aramide, ceramic, etc. In addition, a product obtained by forming a conductive layer such as copper, silver, tin, nickel, gold, etc. on a substrate, for example, a metal thin film attached resin film obtained by forming a metal thin film on the surface of a resin film such as a polyimide film may be used as the substrate.

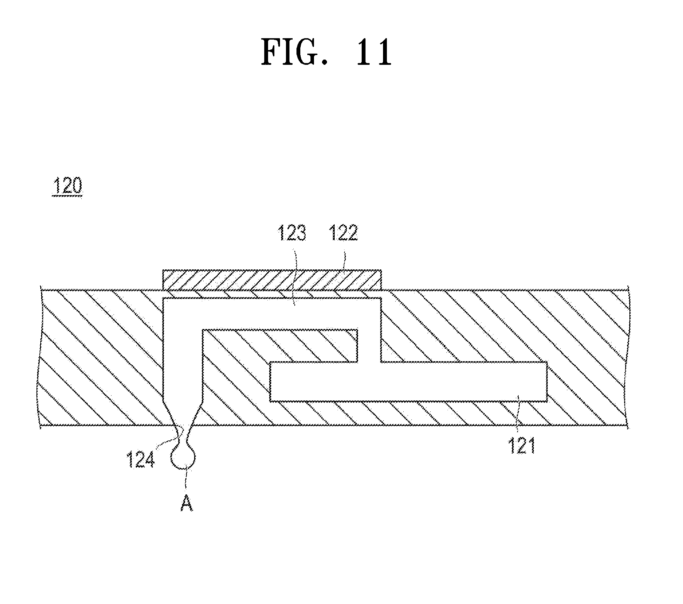

FIG. 11 is a drawing illustrating the discharging state of the coating material A from an inkjet part 120.

The inkjet part 120 includes as shown in FIG. 11, an ink flow path 121 for flowing the coating material A in a liquid state, an ink pressurizing room 123 pressurized by a piezo 122 and an inkjet nozzle 124 for discharging the coating material A pressurized by the ink pressurizing room 123.

In an embodiment, the inkjet nozzles 124 are arranged in the Y-direction as shown in FIG. 10. Since the inkjet technique of a piezo method is known in the art, detailed description thereon will be omitted. In addition, the inkjet part A may be provided with a heating part to maintain the molten state of the coating material A. In addition, the row of the inkjet nozzles 124 may be arranged in plural.

In addition, the temperature of the coating material A during coating is preferably melting point + 20°C and over in consideration of the improvement of dispersibility and is more preferably melting point + 30°C and over. Meanwhile, the upper limit is not specifically limited only if the temperature is less than the boiling point of the paraffin and is preferably about 180°C and less in consideration of the heat-resistance of the inkjet part 120, and more preferably about 140°C and less. In addition, or alternatively, the temperature is more preferably the melting point of the coating material A + 50°C and less.

The thickness of the masking agent A' is not specifically limited, and is preferably about 10-100 µm, and is more preferably about 10-50 µm. In the case that the thickness of the masking agent A' is about 10 µm and over, the generation of pin hole may be restrained. Thus, function as a mask may be sufficiently shown in a following immersing process in a plating solution. Meanwhile in the case that the thickness is 100 µm and less, the deterioration of adhesion of the masking agent A' with an object to be coated W due to the increase of an internal stress or the generation of cracks may be prevented.

In addition, the width of the masking agent A' in the Y-direction is not limited and is set according to a pattern formed. The width may be increased to an optional width by connecting a plurality of the inkjet parts 120 in the Y-direction.

A supplying part 30 includes a tank part 32 for injecting the coating material A in a solid state or a liquid state, a connecting part 33 for connecting the inkjet part 120 and the tank part 32, and a delivering part 34 for delivering the molten coating material A in the tank part 32 via the connecting part 33 to the inkjet part 120.

The heating apparatus 31 includes a first heating part 31A provided at the tank part 32 for melting the coating material A and a second heating part 31B provided at the connecting part 33 for maintaining the molten state of the coating material A. The first heating part 31A is, for example, a halogen lamp heater, however is not limited thereto. In addition, the second heating part 31B is, for example, a heater with a coil shape provided around the connecting part 33, however is not limited thereto.

The tank part 32 may be formed using a material that may endure the heating of the first heating part 31A, without limitation and may include, for example a heat-resistant acryl case.

The connecting part 33 may be formed using a material that may endure the heating of the second heating part 31B and have flexibility, without limitation and may include a heat-resistant silicon tube.

The delivering part 34 includes a pumping instrument.

The coating apparatus 10 includes a control part 140 for moving the inkjet part 120 three-dimensionally with respect to the object to be coated W to control the position thereof and controlling the coating position of the coating material A freely on the object to be coated W, a returning part 50 for returning the object to be coated W with respect to the inkjet part 120 and a temperature controlling part 60 provided at the returning part 50 for controlling the temperature of the object to be coated W.

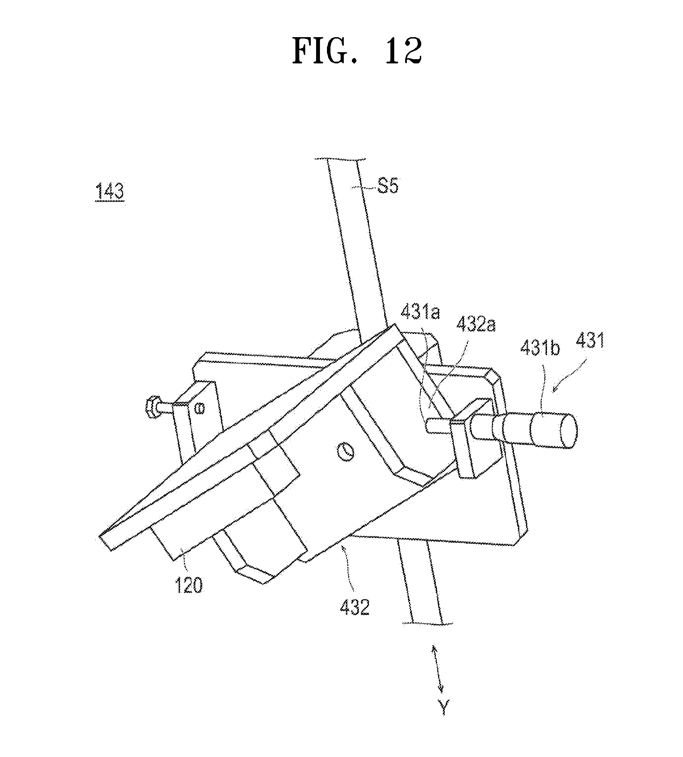

FIG. 12 is a perspective view illustrating the schematic configuration of the control part 140.

The control part 140 includes a first rotationally moving part 141, a second rotationally moving part 142 and a third rotationally moving part 143 for rotating the inkjet part 120 around the axes of the X-direction, the Y-direction and the Z-direction with respect to the object to be coated W as shown in FIG. 10. In addition, each of the first rotationally moving part 141, the second rotationally moving part 142 and the third rotationally moving part 143 has the same constitution, and the first rotational part 141 and the second rotational part 142 will be omitted in FIG. 12 because simple. Hereinafter, the configuration of the third rotationally moving part 143 will be explained referring to FIG. 12.

In the third rotationally moving part 143, the inkjet part 120 is rotated with respect to the object to be coated W around the axis of the Z-direction, and the row of the inkjet nozzles is slanted with respect to the Y-direction.

The third rotationally moving part 143 includes a micrometer 431 and a case 32 for fixing the inkjet part 120.

The micrometer 431 includes a fore-end part 431a provided at the fore thereof and a rotating part 431b provided at the rear thereof.

The case 432 is slidably connected to a supporting part S5 in the Y-direction. According to this configuration, the inkjet part 120 is slidable in the Y-direction, and the coating material A may be coated on the desired position of the carbonization surface S (non-treating surface S2).

The fore-end part 431a rotates the rotating part 431b to move back and forth and push the side 432b of the case 432. Thus, the case 432 makes rotational moving around the axis of the Z-direction, and the inkjet part 120 rotates.

The rotating part 431b makes rotation by sending a signal from a control part not shown to a servomotor connected to the rotating part 431b and not shown. In addition, the rotating part 431b may be rotated manually.

The returning part 50 is a returning part 50 of a roll-to-roll type. The roll-to-roll type is a method of maintaining and supplying the object to be coated W, in which the object to be coated W is taken in a wound state around a roll, coated with the coating material A in the coating apparatus 10, and then wound again around the roll.

The temperature controlling part 60 is attached to the returning part 50 to control the temperature of the object to be coated W during returning. The temperature controlling part 60 may be, for example, a halogen heater without limitation.

The temperature of the object to be coated W during the returning by the returning part is not specifically limited, however is preferably about 24-60°C in view of the restraint of the exfoliation of the masking agent A' by rapid contraction, and is about 50-60°C in view of the improvement of the ink diffusion after coating. Meanwhile, the upper limit is not limited only if less than the melting point of the paraffin constituting the coating material A is less than the melting point of the paraffin, and is preferably about 24-50°C in view of the diffusion of the paraffin and is preferably about 24-30°C in view of the formation of an edge. By the above configuration, the temperature of the object to be coated W may be appropriately controlled, and the ink flow may be prevented.

### (Removing apparatus 70)

The removing apparatus 70 includes a cooling removing part 71 for removing the masking agent A' including the paraffin coated only on the non-treating surface S2 as the coating material A in a solid state by a refrigerant 712 having a temperature less than the melting point of the paraffin from the object to be coated W. The refrigerant 712 is, for example, water and is stored in a water bath 711. The cooling removing part 71 solidifies the paraffin included in the masking agent A' by contacting the refrigerant 712 having a temperature less than the melting point of the paraffin with the masking agent A' and removes the masking agent A' from the object to be coated W.

In addition, the masking agent A' is removed by pure water in this embodiment, however a medium of liquid or gas may be used without limitation. As the liquid, any one among acidic, alkaline and neutral liquid may be used. In the case of using the acidic and alkaline liquid, adverse effects including the discoloration of a metal layer formed by the surface treatment such as plating, etc. may be generated. Thus, in the case of using the liquid, the neutral liquid is preferable. That is, the refrigerant is preferably cold air and/or neutral liquid, and more preferably, the neutral liquid is used. As the cold air, a cold gas of the air, nitrogen, carbon dioxide, etc., may be used.

As the neutral liquid, any neutral liquid that may not dissolve the paraffin may be used without specific limitation, and a known material may be appropriately selected and used in line with the paraffin.

For example, a ketone solvent such as methyl ethyl ketone, acetone, diethyl ketone, methyl isobutyl ketone, methyl isopropyl ketone, cyclohexanone, 3-heptanone, 4-heptanone, etc., an alcohol solvent such as methanol, ethanol, n-propanol, isopropanol, n-butanol, i-butanol, t-butanol, 3-methyl-1-butanol, 1-pentanol, 2-pentanol, n-hexanol, cyclohexanol, 1-heptanol, 1-octanol, 2-octanol, 2-methoxyethanol, allyl alcohol, furfuryl alcohol, phenol, etc. may be used. In addition, the above-described material may be used solely or as a mixture of two or more.

The temperature of the refrigerant 712 is not specifically limited only if the temperature is less than the melting point of the paraffin and the refrigerant could be exfoliated due to the contraction thereof. The contraction percentage of the paraffin depends on the melting point of the paraffin and may be appropriately set according to the melting point of the paraffin used in the masking agent A'. Particularly, the temperature of the refrigerant is preferably about (the temperature of paraffin - 60)°C and less, more preferably about (the temperature of paraffin - 70)°C and less, and more preferably, about (the temperature of paraffin - 80)°C and less for obtaining good exfoliation. In an embodiment, the temperature of the refrigerant is preferably about 25°C and less, more preferably, about 10°C and less, and more preferably, about 5°C and less for simplicity, and particularly preferably, about 0°C and less for decreasing exfoliation time. The lower limit of the temperature of the refrigerant is not specifically limited. For example, in the case of using liquid nitrogen, the temperature may be about -196°C.

The removing apparatus 17 further includes a recovering part at cooling side 72 for recovering the masking agent A' in a solid state removed by the cooling removing part 71 from the refrigerant, and the masking agent A' recovered in the recovering part at cooling side 72 is reused as the coating material A.

The recovering part at cooling side 72 recovers the masking agent A' removed by the cooling removing part 71 and precipitated or floating in a water bath 71. The recovering part at cooling side 72 is not limited only having a configuration of enduring the weight of the masking agent A' recovered and recovering the masking agent A'. The masking agent A' recovered in the recovering part at cooling side 72 may be reused as the coating material A as it is. Otherwise, the masking agent A' may be reused after removing the impurities in the recovered masking agent, for example, metal pieces, metal particles, garbage/dust, etc. produced by plating treatment, etc. However, the recovered masking agent A' may be reused after separation as occasion demands.

### (Coating material A)

Hereinafter, the coating material A coated by the coating apparatus 10 according to an embodiment and the object to be coated W with the coating material A will be explained.

In the present disclosure, paraffin is an alkane having at least 20 carbon atoms (saturated hydrocarbon chain with General Formula of CnH2n+2). Paraffin is chemically very stable and has excellent chemical-resistance (alkaline-resistance/acid-resistance) with respect to a surface treating agent such as an etching solution or a plating solution. Thus, a composition including the paraffin may be used as the masking agent A' during surface treatment such as plating or etching. According to the surface treatment using the masking agent A' including the paraffin, a coating material A in a molten state is coated on a non-treating surface for not conducting surface treating of an object to be treated W (to form a mask pattern), surface treatment such as plating or etching is conducted, and the masking agent A' is solidified and removed by cooling to less than the melting point. In addition, the paraffin is favorable because is highly safe to a human body, and the treatment of the masking agent A' may be improved by preparing the masking agent A' using the paraffin.

The paraffin used in the present invention is not specifically limited, is preferably a saturated hydrocarbon chain having 20-80 carbon atoms, and is more preferably a saturated hydrocarbon chain having 20-40 carbon atoms. In addition, the paraffin may be a linear chain or a branched chain. The paraffin may be formed using a homogeneous material, however is commonly a mixture of at least two kinds of saturated hydrocarbon chains (paraffin) having different carbon chains.

The number average molecular weight (Mn) of the paraffin is preferably about 220-480, and is more preferably about 220-230, and is more preferably about 220-260. Thus, the melting point of the paraffin may be in a desired range, and the adhesion to the object to be coated W and the exfoliating property during cooling may be improved.

In addition, an average carbon number of the paraffin is preferable about 20-40. Generally, as the carbon number increases, the melting point of the paraffin increases. Thus, the melting point of the paraffin may be in the desired range, and the adhesion to the object to be coated W and the exfoliation property during cooling may be improved by changing the number of the carbon included.

The melting point of the paraffin is different according to the use of the coating material A, and paraffin having a solid state at room temperature (about 25°C) is preferable. The melting point of the paraffin is preferably about 40°C and over and is more preferably about 50°C and over. The melting point of the paraffin is further more preferably about 60°C and over and is still further more preferably about 65°C and over. The removal of the masking agent A' or surface treatment (plating treatment, etching treatment), which will be described layer, is necessary to be conducted at a temperature less than the melting point of the paraffin. In this case, the removing of the masking agent A' obtained by including the paraffin and the surface treatment may be easily conducted, and the selection width of the treatment temperatures is preferably wide. Meanwhile, the upper limit of the melting point is not specifically limited. In the case that the melting point is 200°C and less, the coating of the coating material A formed by including the paraffin may be conducted in moderate conditions preferably. Generally, if the melting point of the paraffin increases, the contraction percentage thereof increases, and the paraffin may be easily split. The melting point is more preferably about 150°C and less in consideration of the above points. More preferably, the melting point is about 100°C and less, and particularly preferably, the melting point is about 85°C and less.

As the paraffin, paraffin wax prepared by separating from the effluent by the distillation under reduced pressure of petroleum and purifying regulated in JIS K 2235:2209, synthesized paraffin derived from petroleum mineral, synthesized wax, etc., may be used. PARAFFINWAX series produced by NIPPON SEIRO CO., LTD may be used as commercially available products.

The coating material A may not be composed of only the paraffin. The coating material A may be a masking composition including the paraffin and colorant and other additives, as occasion demands.

The coating material A preferably includes the colorant. The paraffin is in a range of semi-transparent to white at room temperature, and by adding the colorant, the visibility of the coating material A coated on the non-treating surface may be improved. The colorant is not specifically limited, and known pigments and/or dyes may be used.

As the pigment, a magenta pigment such as Pigment Red 3, 5, 19, 22, 31, 38, 43, 48:1, 48:2, 48:3, 48:4, 48:5, 49:1, 53:1, 57:1. 57:2, 58:4. 63:1, 81, 81:1, 81:2, 81:3, 81:4, 88, 104, 108, 112, 122, 123, 144, 146, 149, 166, 168, 169, 170, 177, 178, 179, 184, 185, 208, 216, 226, 257, Pigment Violet 3, 19, 23, 29, 30, 37, 50, 88, Pigment Orange 13, 16, 20, 36, etc., a cyan pigment such as Pigment Blue 1, 15, 15:1, 15:2, 15:3, 15:4, 15:6, 16, 17-1, 22, 27, 28, 29, 36, 60, etc., a green pigment such as Pigment Green 7, 26, 36, 50, etc., a yellow pigment such as Pigment Yellow 1, 3, 12, 13, 14, 17, 34, 35, 37, 55, 74, 81, 83, 93, 94, 95, 97, 108, 109, 110, 137, 138, 139, 153, 154, 155, 157, 166, 167, 168, 180, 185, 193, etc., a black pigment such as Pigment Black 7, 28, 26, etc., a white pigment such as Pigment White 6, 18, 21, etc. may be used according to the purpose.

As the dye, an oil soluble dye substantially insoluble in water is preferable. For example, C.I. solvent black 3, 7, 27, 29 and 34, C.I. solvent yellow 14, 16, 19, 29, 30, 56, 82, 93 and 162, C.I. solvent red 1, 3, 8, 18, 24, 27, 43, 49, 51, 72, 73, 109, 122, 132 and 218, C.I. solvent violet 3, C.I. solvent blue 2, 11, 25, 35, 67 and 70, C.I. solvent green 3 and 7, and C.I. solvent orange 2, etc., may be used. In the present disclosure, the oil soluble dye has solubility (amount of the dye soluble in 100 g of water) of about 1 g and less, preferably, about 0.5 g and less, and more preferably, about 0.1 g and less in water at about 25°C.

The dye and/or pigment may be used solely or as a mixture of two or more.

When a colorant such as a pigment present in a solid state is used in the coating material A, the average diameter of the colorant particles is preferably about 1-20 µm, more preferably about 1-10 µm, more preferably about 1-5 µm, and more preferably about 1-2 µm. In the above-described range, the blocking of an inkjet nozzle may be prevented, and the conservation stability may be maintained.

The coating material A may include the additive such as a dispersing agent for improving the dispersibility of the colorant, a surfactant for controlling the surface tension of the coating material A, a viscosity controlling agent, an adhesiveness imparting agent to improve adhesiveness, a plasticizer for imparting flexibility, an antioxidant for imparting thermal stability, etc.

The amount of the paraffin in the coating material A is preferably from about 85 wt% to about 100 wt% based on the total amount of the coating material A for sufficiently exhibiting chemical-resistance, is more preferably from about 90 wt% to about 99.99 wt% for preventing chemical reaction with a plating solution, and is more preferably from about 95 wt% to about 99.99 wt% for further preventing chemical reaction with a plating solution.

The amount of the colorant in the coating material A may be appropriately selected according to the use, and is preferably about 0.01-10 wt%, is more preferably about 0.01-5 wt%, and is more preferably about 0.01-1 wt% based on the total amount of the coating material A in consideration of the dispersibility and the coloring property of the coating material A.

The amount of other additives in the coating material A is not specifically limited in a range of not damaging the effects of the present invention and is commonly and preferably from about 0.1 parts by weight to about 10 parts by weight based on the total amount (100 parts by weight) of the paraffin and the colorant.

The preparation of the coating material A including the colorant and/or the additive may be conducted by mixing paraffin in a molten state and a colorant and/or an additive using a dispersing apparatus such as a ball mill, a sand mill, an art writer, a roll mill, an agitator, a Henschel mixer, a colloidal mill, a sonic homogenizer, a pearl mill, a wet zet mill, a paint shaker, etc.

The viscosity of the coating material A is preferably about 5-30 mPa·s at about 80°C. In this range, diverse coating apparatuses and coating methods including an inkjet method may be applied. Generally, the viscosity is preferably high in consideration of the prevention of ink flow after discharging, however if the viscosity is too high, the diffusion of the ink is not good, and the formation of a uniform coating surface may be difficult even though increasing resolution. Thus, the viscosity is preferably about 5-20 mPa·s, and is more preferably about 8-20 mPa·s. The viscosity of the coating material A may be controlled to a desired range by controlling the composition of the paraffin (the kind and the amount ratio of saturated hydrocarbon chain) constituting the coating material A or by adding a viscosity controlling agent.

In this embodiment, the coating material A obtained by mixing 100 parts by weight of paraffin wax (melting point of about 95°C) and 5 parts by weight of a pigment as the colorant was used. The viscosity of the coating material A was measured using a rotary type viscometer (for example, TVB-35, etc. manufactured by TOKI SANGYO CO., LTD.) and was about 12 mPa·s at about 80°C.

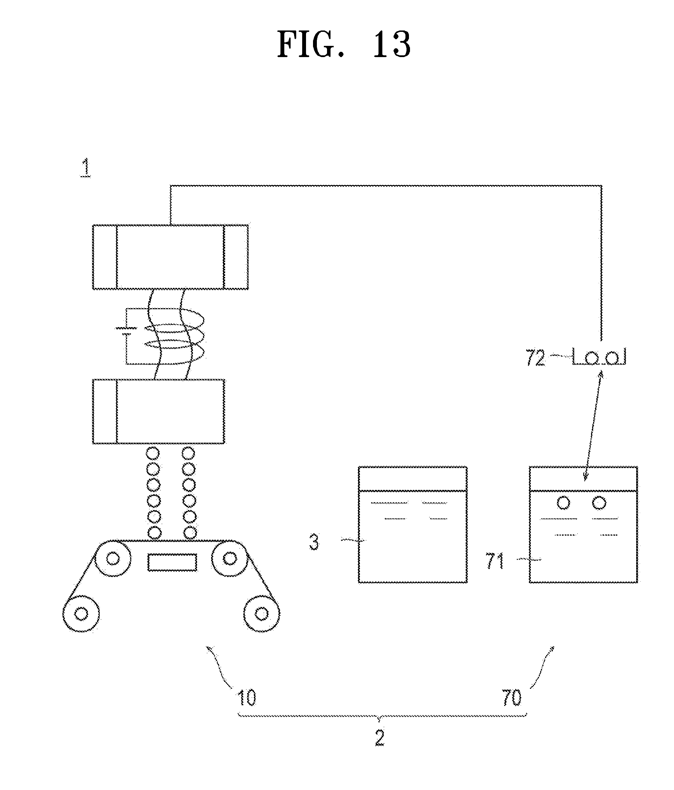

In the coating removing system 2 configured as described above, a certain surface treatment on the treating surface S1 of the object to be coated W may be conducted by conducting the certain surface treatment with respect to the object to be coated W on which the masking agent A' is coated on a non-treating surface S2, and removing the masking agent A' from the non-treating surface S2 of the object to be coated W. Hereinafter, a method of plating the treating surface S1 of the object to be coated W will be explained as an embodiment referring to FIGS. 13 to 17.

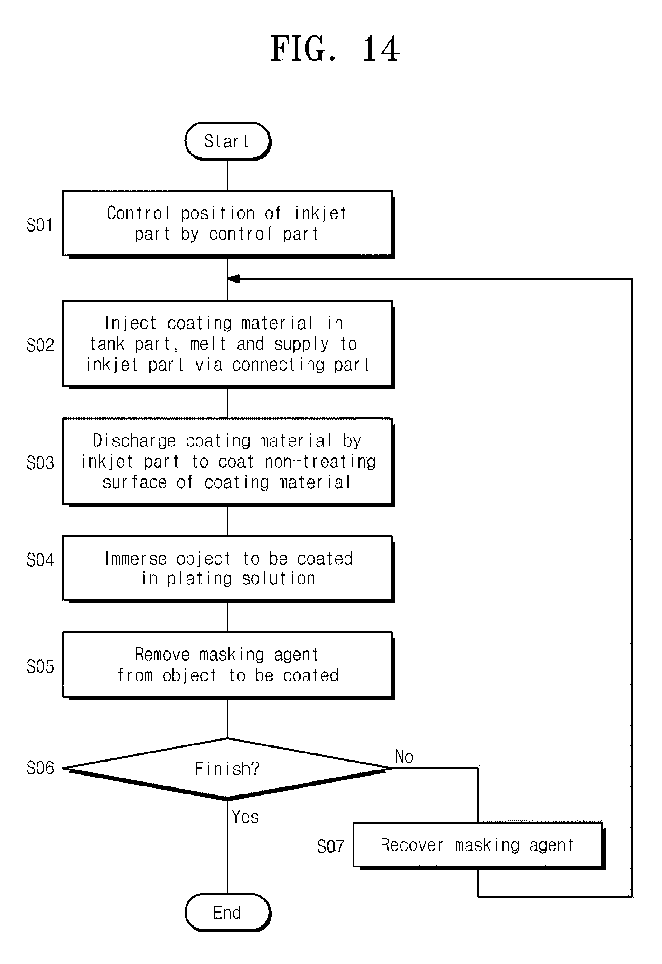

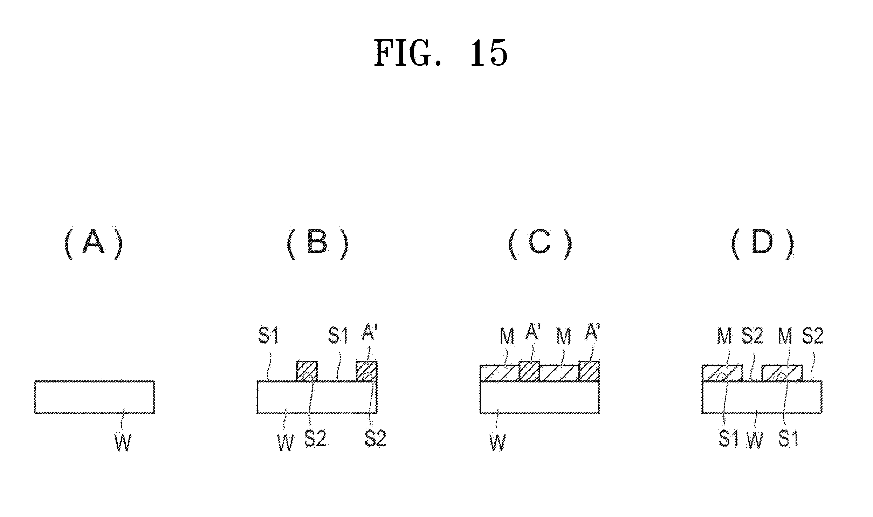

FIG. 13 is a drawing illustrating a plating treating unit 1 including the coating removing system 2. The plating treatment unit 1 includes the plating removing system 2 and a plating immersing part 3. FIG. 14 is a flowchart illustrating a plating treating method using the plating treating unit 1 shown in FIG. 13. FIG. 15 is a drawing illustrating a state of an object to be coated after finishing each process by the plating treating unit 1 shown in FIG. 13. FIG. 15(A) is an initial state, FIG. 15(B) is a state after finishing a discharging process, FIG. 15(C) is a state after being immersed in a plating solution, and FIG. 15(D) is a state after finishing a cooling removing process.

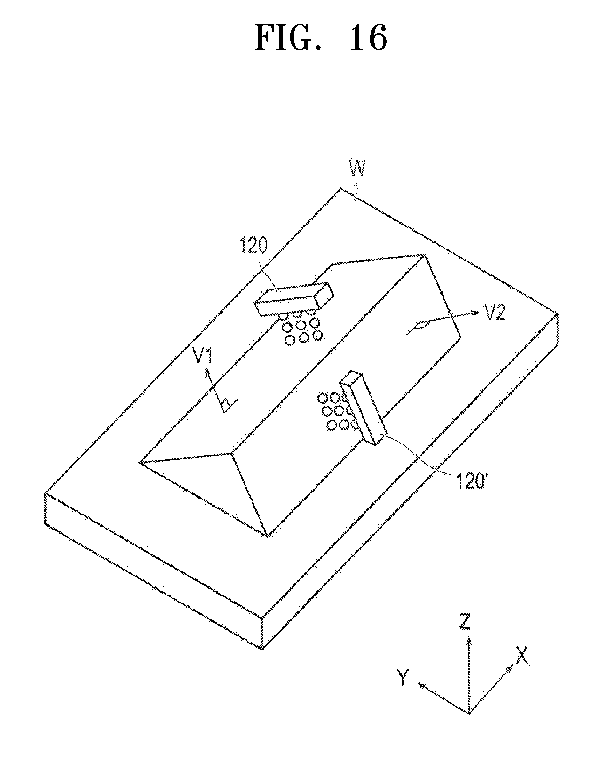

In Step S01, the position of the inkjet part 120 is controlled by the control part 140 (controlling process). In this embodiment, two coating apparatuses 10, that is, two inkjet parts 120 (first inkjet part 120 and second inkjet part 120') are provided as shown in FIG. 16. Particularly, in the case that the object to be coated W has non-treating surfaces S2 in two different and perpendicular directions V1 and V2, the first inkjet part 120 is rotated around X-axis and Y-axis so that the coating material A is discharged in direction V1 by the first rotationally moving part 141 and the second rotationally moving part 142, and the second inkjet part 120' is rotated around the X-axis and the Y-axis so that the coating material A is discharged in direction V2.

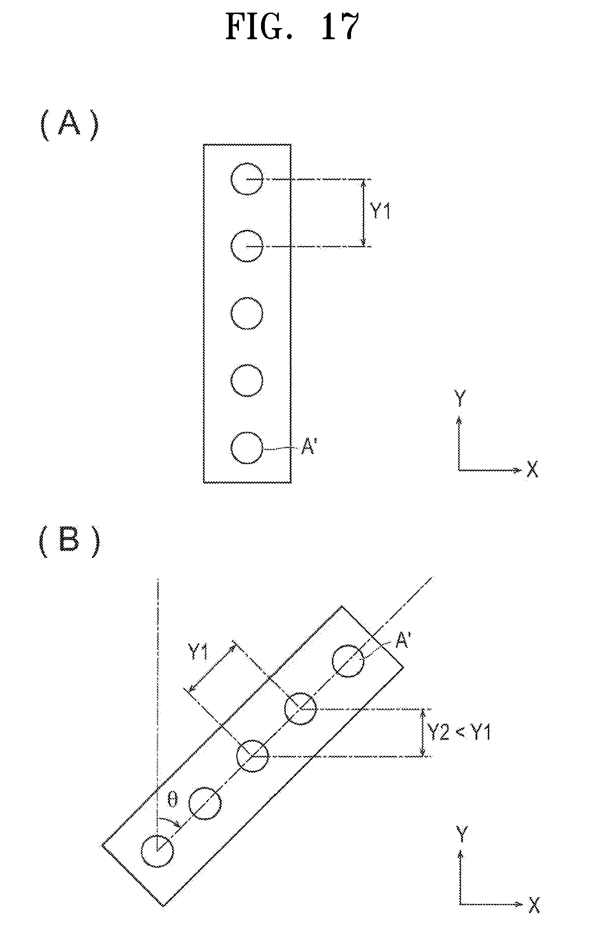

In addition as shown in FIG. 17, the inkjet part 120 is rotated by θ° around Z-axis with respect to the object to be coated W by the third rotationally moving part 143. By rotating the inkjet part 120 by θ° around the Z-axis, the row of the inkjet nozzles 124 is slanted by θ° from the Y-direction. If the pitch between inkjet nozzles 214 is set to Y1, the component in the Y-direction of the pitch between the inkjet nozzles 124 after slanting, Y2 is Y1 x cosθ. As described above, since the row of the inkjet nozzles 124 is provided only a row, the computation of Y2, the component in the Y-direction of the pitch between the inkjet nozzles 124 after slanting may be easy. Since the component in the Y-direction of the pitch between the inkjet nozzles 124 after slanting, Y2 is Y1 x cosθ, the component in the Y-direction of the pitch between the inkjet nozzles 124, Y2 may be decreased by approaching the slating angle θ to about 90°. In the case that the pitch Y1 between the inkjet nozzles 124 is relatively large when compared to the diameter of the coating material A during discharging, the coating may be conducted so that gaps may not be generated in the Y-direction of continuously carbonized masking agent A', and defects of plating treating on the gaps in the Y-direction of the carbonized masking agent A' may not be prevented.

In Step S02, the coating material A is injected and melted in a tank part 32 and is supplied to an inkjet part 120 via a connecting part 33 (supplying process). Particularly, the coating material A of a solid shape or a liquid state is injected in the tank part 32 (injecting process). Then, the coating material A in a solid state is heated to about 140°C by a first heating part 31A provided at the tank part 32 and melted (melting process). The molten state of the coating material A is maintained by the second heating part 31B provided around the connecting part 33 (melting maintaining process), and the coating material A is delivered by the delivering part 34 from the tank part 32 to the inkjet part 120 (delivering process).

In Step S03, the coating material A is discharged by the inkjet part 120 and is coated on the non-treating surface S2 of the object to be coated W (discharging process). Particularly, the coating material A in a liquid state supplied via the connecting part 33 flows via an ink flow path 121 and flows in an ink pressurizing room 123. In addition, the ink pressurizing room 123 is modified by applying an appropriate voltage to an appropriate piezo 122 among a plurality of piezo 122 so that only the non-treating surface S2 is coated. In addition, the coating material A (about 120°C) is discharged from the inkjet nozzle 124 and to be coated on the non-treating surface S2 (see FIG. 15(B)).

In Step S04, the object to be coated W is immersed in a plating solution. Particularly, the object to be coated W coated with the masking agent A' on the non-treating surface S2 is immersed in the plating solution of a plating immersing part 3. As a result, a metal layer M is formed on the treating surface S1 of the object to be coated W (see FIG. 15(C)). In addition, the object to be treated W may be pre-treated in advance of the immersing in the plating solution to improve the adhesiveness of the object to be coated W and the metal layer M, etc. The pre-treatment may include, for example, cleaning treatment, etching treatment, forming of a bottom layer, etc., such as blast treatment, alkaline washing, acid washing, washing, washing with an organic solvent, bombard treatment, etc. As the constituting materials of the metal layer M, for example, Ni, Cu, Ag, Au, Cr, Zn, Sn, a Sn-Pb alloy, etc., may be included. The thickness of the metal layer M formed by the plating treatment is not specifically limited and is preferably about 0.5 µm and over for exhibiting sufficient conductivity. Meanwhile, the upper limit of the thickness is not specifically limited. The plating treating method is not specifically limited, and for example, electroplating, electroless plating, etc., may be conducted. The temperature of plating treatment is dependent on the kind of a plating solution and a plating method (electroplating, electroless plating). Commonly, the temperature of the plating solution is about 40-80°C for the electroless plating and about 20-70°C and preferably about 50-65°C for the electroplating. In the case of using an alkaline, cyan solution, the temperature of electroplating treatment is about 50°C and over. In addition, the electroless plating treatment is conducted at about 50°C and over in many cases. In the present invention, the temperature is not specifically limited only if the melting of the masking agent A' is prevented during plating treatment, and the temperature less than the melting point of paraffin constituting the masking agent A' may be applied. Preferably, the plating treatment is conducted at the temperature less than the melting point of the paraffin - 10°C. In a particularly preferable embodiment, the masking agent A' is formed using paraffin with a melting point of the temperature of plating treatment (temperature of plating solution) + 10°C to + 50°C, more preferably, the temperature of plating treatment (temperature of plating solution) + 10°C to + 30°C. That is, the plating treatment is particularly preferably conducted at the temperature of the melting point of paraffin - 10°C to - 50°C, more preferably, the temperature of the melting point of paraffin - 10°C to - 30°C.

Hereinafter, an embodiment of the plating solution and plating conditions in this embodiment will be illustrated.

**[Table 1]**

| | Bath of low concentration | Bath of high concentration | 23K bath |
|---|---|---|---|
| Gold potassium cyanide | 1-4 g/L | 10-30 g/L | 8 g/L |
| Citrates | Na salt 40 g/L | Na salt 40 g/L | Acid+Na salt 80 g/L |
| Citric acid | 40 g/L | 40 g/L | |
| Nickel sulfamate | | | 3 g/L |
| Zinc acetate | | | 0.3 g/L |
| pH | 3-6 | 2.5-6.5 | 4-5 |
| | | | |
| Temperature (°C) | Room temperature | 30-60 | 21 |
| Cathode current density (A/dm2) | 0.5-1.0 | 0.1-0.8 | 1 |

The object to be coated W is immersed in a plating solution (pH=4, plating solution shown in the above Table 1) at about 65°C for about 1 hour, and a 14K gold plated layer with a thickness of about 0.2-1 µm is formed.

In Step S05, the masking agent A' is removed from the object to be coated (cooling removing process). Particularly, an object to be coated W, in which a metal layer M is coated on the treating surface S1, and the masking agent A' is coated on the non-treating surface S2, is immersed in water in a water bath 711 of a removing apparatus 70. As a result, the masking agent A' coated on the non-treating surface S2 is removed from the non-treating surface S2 (see FIG. 15(D)). Immersing time is dependent on the temperature of a liquid and is commonly from about 30 seconds to about 5 minutes and is more preferably from about 5 minutes to about 30 minutes. In addition, ultrasonic vibration may be applied during immersing on occasion demands.

In Step S06, the finishing of the plating treatment is judged. In the case of judging the finish of the plating treatment (S06: YES), the treatment is finished.

Meanwhile, in the case of judging the un-finished state of the plating treatment (S06: NO), the treatment of S07 is conducted, followed by the back to the treatment of S02.

In Step S07, the masking agent A' removed in Step S05 is recovered by the recovering part at cooling side 72 (recovering process at cooling side). Particularly, the masking agent A' having a solid shape removed from the non-treating surface S2 and floating or precipitated in the water bath 711 is recovered. The recovered masking agent A' is injected to the tank part 32 again and reused as the coating material A.

As described above, according to the plating treating method by the flowchart shown in FIG. 14, plating treatment may be easily conducted in a minute region with high degree of precision.

In addition, by the plating apparatus 10 according to an embodiment, the masking agent may be coated accurately on all parts of the non-treating surface, and the plating solution is not coated on an unnecessary part, and the loss of a plating material may be prevented.

### (Embodiment B)

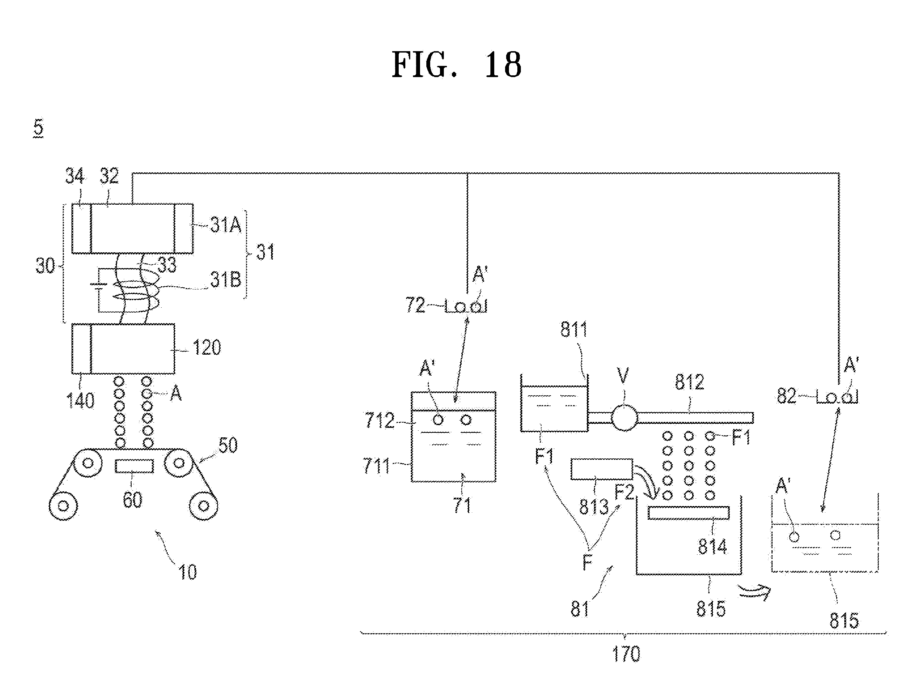

Then, a coating removing system 5 according to Embodiment B of the present invention will be explained referring to FIG. 18. This embodiment is different from Embodiment A in that the removing apparatus 170 further includes a melting removing part 81 and a recovering part at melting side 82. Hereinafter, the explanation of the common part as the coating removing system 2 according to Embodiment A will be omitted, and the characteristic portion of the coating removing system 5 of this embodiment will be explained.

The coating removing system 5 according to this embodiment includes a coating apparatus 10 and a removing apparatus 170 as shown in FIG. 18. The removing apparatus 170 includes a cooling removing part 71, a recovering part at cooling side 72, a melting removing part 81 and a recovering part at melting side 82. The configuration of the cooling removing part 71 and the recovering part at cooling side 72 is the same as in Embodiment A, and detailed description thereon will be omitted.

The melting removing part 81 removes the coating material A remaining at the non-treating surface S2 after conducting removing by the cooling removing part 71 by dissolving in a fluid F having a temperature more than the melting point of the paraffin to obtain a liquid state from the object to be coated W.

The melting removing part 81 includes a liquid storing part 811, a liquid dropping part 812, a hot air supplying part 813, a disposing part 814 and a liquid recovering part 815.

The liquid storing part 811 stores the liquid F1. The liquid storing part 811 is provided with a heating source that is not shown, to control the temperature of the liquid F1.

The liquid dropping part 812 drops the liquid F1 on the object to be coated W disposed on the disposing part 814. The liquid dropping part 812 drops the liquid F1 by opening a valve V and supplying the liquid F1 from the liquid storing part 811 storing the liquid F1.

The hot air supplying part 813 provides hot air F2 to the disposed object to be coated W at the disposing part 814.

The liquid recovering part 815 recovers the liquid F1 and the masking agent A' molten in the liquid F1.

The liquid F1 and the hot air F2 forms the fluid F.

The liquid F1 is, for example, hot water. In addition, a liquid such as a refrigerant 712 may be used without limitation. The temperature of the liquid F1 is not specifically limited only if more than the melting point of the paraffin. In addition, the temperature of the hot air F2 is not specifically limited only if more than the melting point of the paraffin.

The recovering part at melting side 82 makes the masking agent A' removed by the melting removing part 81 in a liquid state and recovers. The masking agent A' recovered by recovering part at melting side 82 is reused as the coating material A.

The recovering part at melting side 82 recovers the masking agent A' removed at the melting removing part 81, recovered by the liquid recovering part 815 and precipitated or floating in the liquid recovering part 815 after a period of time. The configuration of the recovering part at melting side 82 is not specifically limited only if enduring the weight of the recovered masking agent A' and recovering only the masking agent A'.

The masking agent A' recovered by the recovering part at melting side 82 may be reused as the coating material A as it is. Otherwise, the masking agent A' may be reused after removing the impurities in the recovered masking agent A', for example, metal pieces, metal particles, garbage/dust, etc. produced by plating treatment, etc. However, the recovered masking agent A' may be reused after separation as occasion demands.

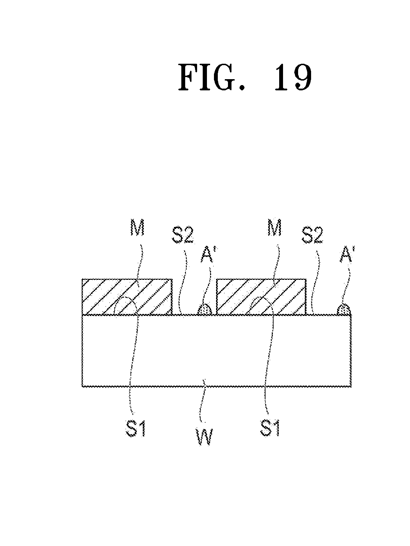

In the coating removing system 5 having the above configuration, a kind of surface treatment is conducted with respect to the treating surface S1 of the object to be coated W by conducting a kind of surface treatment on the non-treating surface S2 of the object to be coated W and removing the masking agent A' from the non-treating surface S2 of the object to be coated W. Hereinafter, a method of plating treating on the treating surface S1 of the object to be coated W will be explained referring to FIGS. 14 and 19. In addition, the procedure to Step S04 is the same as in Embodiment A, and processes after Step S05 will be explained.

In Step S05, the masking agent A' is removed from the object to be coated W (cooling removing process, melting removing process). Particularly, the cooling removing process is conducted as explained in Embodiment A. FIG. 19 is a drawing of the object to be coated W after finishing the cooling removing process. As shown in FIG. 19, the masking agent A' remains on the non-treating surface of the object to be coated W. Then, the object to be coated W is taken from the water bath 711 and the object to be coated W is disposed in the disposing part 814. Then, hot air F2 is supplied from a hot air supplying part 813 to the object to be coated W, and the masking agent A' remaining on the non-treating surface S2 of the object to be coated W is molten. Then, the valve V is opened, and the liquid F1 stored in the liquid storing part 811 is dropped from the liquid dropping part 812 to the non-treating surface S2 of the object to be coated W. As a result, the liquid F1 and the masking agent A' molten by the liquid F1 is recovered by the liquid recovering part 815.

In Step 06, the finishing of the plating treatment is judged. In the case of judging the finish of the plating treatment (S06: YES), the treatment is finished.

Meanwhile, in the case of judging the un-finish of the plating treatment (S06: NO), the treatment of S07 is conducted, followed by the back to the treatment of S02.

In Step S07, the masking agent A' removed in Step S05 is recovered by the recovering part at cooling side 72 and the recovering part at melting side 82 (recovering process at cooling side, recovering process at melting side). The recovering method is the same as in Embodiment A, and detailed explanation thereon will be omitted.

### (Embodiment C)

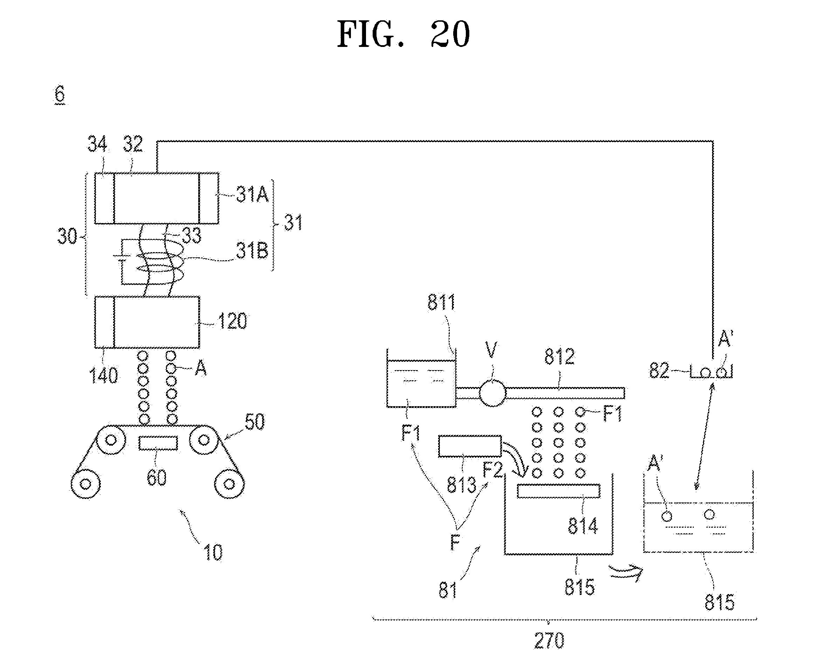

Then, a coating removing system 6 according to Embodiment C will be explained referring to FIG. 20. The removing apparatus 270 in this embodiment is different from Embodiment A and Embodiment B in including a melting removing part 81 and a recovering part at melting side 82.

The coating removing system 6 according to this embodiment includes a melting removing part 81 for removing the masking agent A' including paraffin which is a solid at room temperature and has a hot melt property of being liquefied by heating as the coating material A coated only on a non-treating surface S2 of an object to be coated W including a treating surface S1 for surface treating and a non-treating surface S2 for surface non-treating by dissolving in a liquid F1 having a temperature more than the melting point of the paraffin to make a liquid state. In addition, the coating removing system 6 includes a recovering part at melting side 82 for recovering the masking agent A' in a liquid state removed by the melting removing part 81 after making it in a solid state to reuse the masking agent A' recovered by the recovering part at melting side 82 as the coating material A. The configuration of the melting removing part 81 and the recovering part at melting side 82 is the same as that in Embodiment B, and detailed explanation thereon will be omitted.

Hereinafter, a modified embodiment of the above embodiments will be illustrated.

### (Modified embodiment)

In the above embodiments, the coating material A is discharged to a certain direction by controlling the position of the inkjet part 120 using the control part 140, however the coating material A may be discharged by maintaining the inkjet part by a fixed holder for discharging in a predetermined direction.

In addition, the delivering part 34 is composed of a pump instrument that may be a natural flow instrument for the flow of the molten coating material A from a higher place to a lower place and delivering by disposing the tank part 32 higher than the inkjet part 120.

In addition, two inkjet parts 120 are provided in the above embodiment, however the inkjet part 120 may be one or three.

In the above embodiment, the position of the inkjet part 120 is controlled with respect to the object to be coated W by the control part 140, however the position of the object to be coated W may be controlled with respect to the inkjet part 120 by the control part 140.

In addition, in the above embodiment, the surface treatment is conducted in the atmosphere after melting the coating material A by the heating apparatus 31, however the melting of the coating material A and the surface treating may be conducted in a thermostat.

In addition, the plating treatment is conducted as the surface treatment in the above embodiment, however other surface treatment such as etching treatment, etc. may be conducted.

### Examples

Hereinafter, the present invention will be described according to examples and comparative examples. However, the present invention is not interpreted by limiting thereto.

### [Example 1-1: Formation of mask pattern]

### (1) Production of masking agent

100 parts by weight of paraffin wax (melting point: 95°C) and 5 parts by weight of a pigment as a colorant were mixed to produce a masking agent. The viscosity of the masking agent was measured using a rotary type viscometer (for example, TVB-35, etc. manufactured by TOKI SANGYO CO., LTD.), and the result was about 12 mPa·s at about 80°C.

### (2) Production of masking solution

The masking agent thus produced was injected in an ink supplying apparatus provided with heating and melting function and attached to an inkjet apparatus and heated to about 140°C to melt and produce the masking solution.

### (3) Patterning of masking solution

The masking solution in a molten state (about 120°C) was dropped from an inkjet head of an inkjet apparatus (jeton manufactured by JE INTERNATIONAL CORP.) on a substrate having a copper layer having a thickness of about 0.5 mm on a polyimide film while maintaining the temperature of the substrate to about 25°C and was selectively patterned. Thus, a mask layer (mask pattern) having a thickness of about 30 µm was formed on the substrate.

### [Example 1-2: Formation of mask pattern]

### (1) Production of masking agent

A masking agent was produced by conducting the same procedure described in the above Example 1-1 using paraffin wax (melting point: about 85°C) instead of the paraffin wax of Example 1-1. The viscosity of the masking agent was measured using a rotary type viscometer (for example, TVB-35, etc. manufactured by TOKI SANGYO CO., LTD.), and the result was about 13 mPa·s at about 80°C.

### (2) Production of masking solution

Then, a masking solution was produced using the masking agent produced above by conducting the same procedure described in Example 1-1.

### (3) Patterning of masking solution

The masking solution in a molten state (about 120°C) was dropped from an inkjet head of an inkjet apparatus (jeton manufactured by JE INTERNATIONAL CORP.) on a substrate having a copper layer having a thickness of about 0.5 mm on a polyimide film while maintaining the temperature of the substrate to about 25°C and was selectively patterned. Then, the pattern printed substrate was heated to about 90°C for about 10 seconds using a heat block to melt ink and bury gaps between inks of a dot shape. Thus, a mask layer (mask pattern) having a thickness of about 15 µm was formed on the substrate.

### [Example 1-3: Formation of mask pattern]

### (1) Production of masking agent

A masking agent was produced by conducting the same procedure described in the above Example 1-2.

### (2) Production of masking solution

Then, a masking solution was produced using the masking agent produced above by conducting the same procedure described in Example 1-1.

### (3) Patterning of masking solution

A mask layer (mask pattern) having a thickness of about 15 µm was formed on the substrate by conducting the same procedure described in Example 1-2 except for not conducting heating of the substrate after selectively printing the masking solution.

### [Example 1-4: Formation of mask pattern]

### (1) Production of masking agent

A masking agent was produced by conducting the same procedure described in the above Example 1-2.

### (2) Production of masking solution

Then, a masking solution was produced using the masking agent produced above by conducting the same procedure described in Example 1-1.

### (3) Patterning of masking solution

The masking solution in a molten state (about 120°C) was dropped from an inkjet head of an inkjet apparatus (jeton manufactured by JE INTERNATIONAL CORP.) on a substrate having a copper layer having a thickness of about 0.5 mm on a polyimide film while maintaining the temperature of the substrate to about 40°C using a heat block and was selectively patterned. Thus, a mask layer (mask pattern) having a thickness of about 15 µm was formed on the substrate.

### (Consideration)

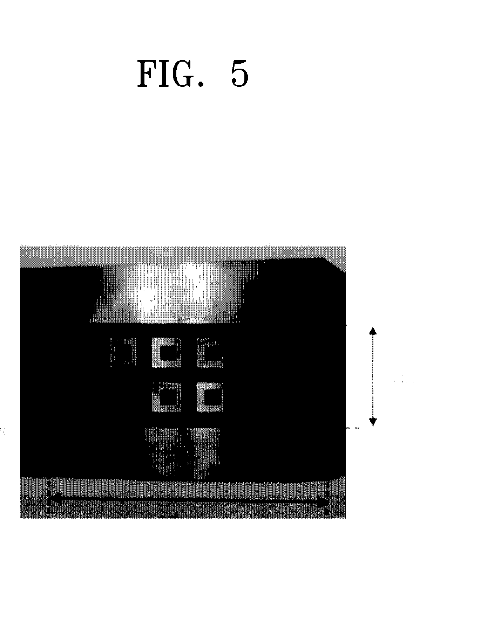

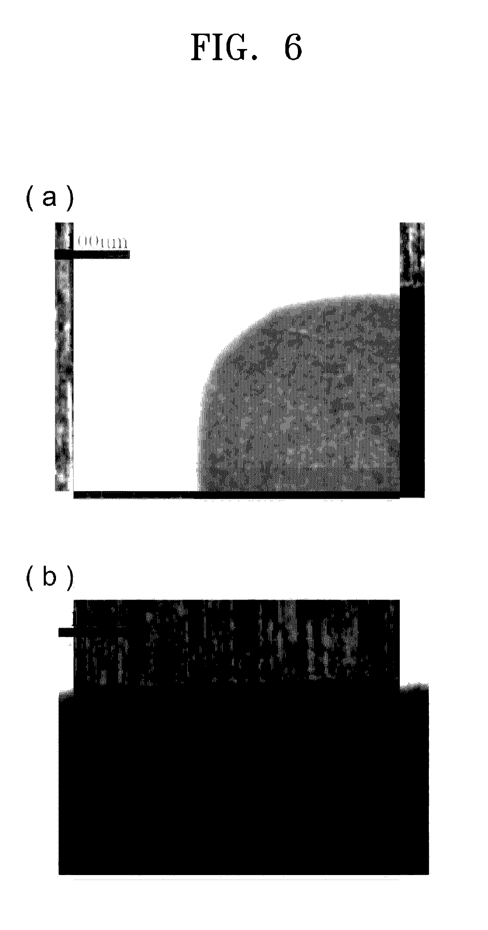

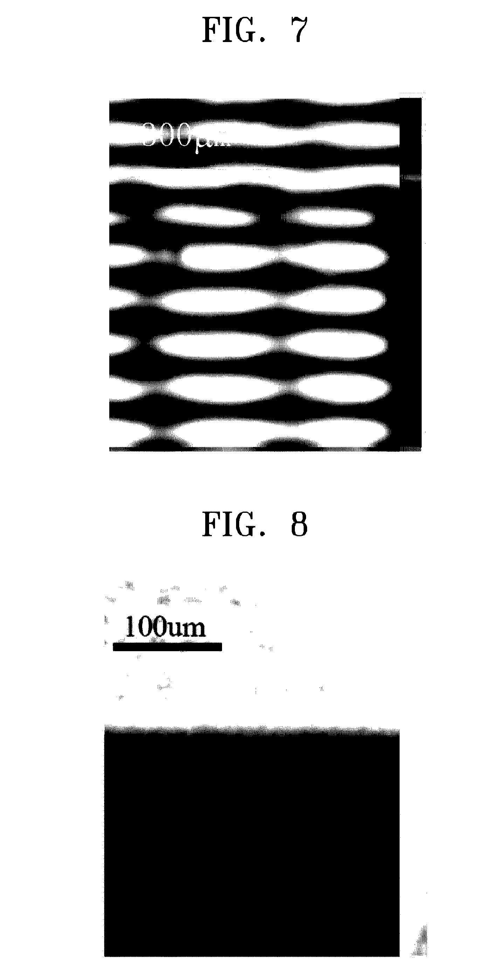

Optical microscope images of the mask patterns obtained in Examples 1-1 to 1-4 are shown in FIGS. 5 to 8. FIG. 5 is a photographic image of the mask pattern obtained in Example 1-1. FIG. 6 is an optical microscope image of the mask pattern obtained in Example 1-2 where (A) is an optical microscope image of the mask pattern of an edge part, and (B) is an optical microscope image of the mask pattern of a line part. FIG. 7 is an optical microscope image of the mask pattern obtained in Example 1-3. FIG. 8 is an optical microscope image of the mask pattern obtained in Example 1-4.

The formation of the mask pattern using the masking agent including paraffin according to the present invention may be secured from FIGS. 5 to 8. In addition, as shown in FIG. 7, it may be confirmed that the mask pattern obtained in Example 1-3 is formed from the masking agent (ink) having a dot shape, and gaps (grooves) are present between inks. On the contrary, in the mask patterns obtained in Example 1-1 (FIG. 6), in which the mask pattern is formed thick, Example 1-2 (FIG. 6), in which the mask pattern is formed and heated or Example 1-4 (FIG. 8), in which the substrate is heated during coating the masking solution, the gaps (grooves) of the masking agent between inks are not confirmed. Particularly, the formation of a caved edge is confirmed even though the mask pattern is formed thin in Example 1-2 (FIG. 6), in which the mask pattern is formed and heated or Example 1-4 (FIG. 8), in which the substrate is heated during coating the masking solution.

From the above description, it may be confirmed that the pores (gaps) between inks may be decreased, the resolution of the dot pitch of the ink may be significantly improved, and the caved edge may be formed at the same time even though the mask pattern is formed thin by a simple method of heating or heat-retaining the substrate during coating masking using the masking agent including the paraffin or heating the substrate coated with the masking solution after coating the masking solution according to the present invention.

### [Example 2-1: Formation of surface treated base (etching treatment)]

### (1) Production of masking agent

A masking agent was produced by conducting the same procedure described in the above Example 1-1.

### (2) Production of masking solution

Then, a masking solution was produced using the masking agent produced above by conducting the same procedure described in Example 1-1.

### (3) Production of masking agent, production of masking solution and patterning of masking solution

A mask layer (mask pattern) was formed on the substrate by patterning of the masking solution by the same procedure described in Example 1-1

### (4) Etching treatment

The substrate having the mask pattern was immersed in the following cupric chloride solution at about 50°C for about 10 minutes.

### [Formula 1]

### (Cupric solution)

· Specific gravity: about 1.354
   · Hydrochloric acid concentration: about 1.6 N
   · Temperature: about 50°C
   · Pressure: about 2 kgf/cm2
   · Cupric concentration: about 200 g/L
   · Cuprous concentration: about 0.5 g/L and less

When observing the substrate after immersion, the exfoliation or dissolution of the mask pattern was not observed, and it was secured that the masking agent has acidity with respect to an acidic solution. In addition, the copper of the non-formed part (copper exposed part) of the mask pattern was etched and dissolved.

### (5) Removing/recovering masking agent

Then, the substrate was washed with ultrasonic wave for about 5 minutes in a water bath storing pure water (pH=6-7), and the masking agent composing the mask pattern was removed. Thus, a surface treated substrate having a copper pattern was obtained.

The masking agent removed after washing was floating in the pure water. The floating masking agent was recovered and dried. The recovered masking agent was heated to about 140°C and melted to regenerate the masking agent. The regenerated masking agent is reusable as it is.

### [Example 2-2: Formation of surface treated base (plating treatment)]

### (1) Production of masking agent

A masking agent was produced by conducting the same procedure described in the above Example 1-1.

### (2) Production of masking solution

Then, a masking solution was produced using the masking agent produced above by conducting the same procedure described in Example 1-1.

### (3) Patterning of masking solution

The masking solution in a molten state (about 120°C) was dropped from an inkjet head of an inkjet apparatus (jeton manufactured by JE INTERNATIONAL CORP.) on a connector frame as a substrate (substrate configuration: a metal pattern having a thickness of about 5-10 µm formed by etching and press molding on a copper plate) while maintaining the temperature of the substrate to about 25°C and was selectively patterned. Thus, a mask layer (mask pattern) having a thickness of about 30 µm was formed on the substrate.

### (4) Plating treatment

The substrate with the mask pattern formed thereon was immersed in a plating solution (pH=4, acidic gold plating solution shown in the following Table) at about 65°C for about 1 hour, and a 14K gold plated layer with a thickness of about 0.2-1 µm was formed.

**[Table 2]**

| Acidic gold plating solution | |
|---|---|
| | Bath of high concentration |
| Gold potassium cyanide | 10-30 g/L |
| Citrates | Na salt 40 g/L |
| Citric acid | 40 g/L |
| Nickel sulfamate | |
| Zinc acetate | |
| Cathode current density (A/dm2) | 0.1-0.8 |

### (5) Removing/recovering masking agent

Then, the substrate was washed with ultrasonic wave for about 5 minutes in a water bath storing pure water (pH=6-7), and the masking agent composing the mask pattern was removed. Thus, a surface treated substrate having a copper pattern was obtained.

The masking agent removed after washing was floating in the pure water. The floating masking agent was recovered and dried. The recovered masking agent was heated to about 140°C and melted to regenerate the masking agent. The regenerated masking agent is reusable as it is.

In addition, the present invention application is based on the application of Japanese Patent Application No. 2012-198563, and all disclosed contents are hereby referred to and considered.

### Designation of reference numerals

- 20, 40: Surface treating apparatus
- 21, 41: Substrate
- 22, 42: Mask pattern
- 23, 43: Metal layer
- 1: Plating treating unit
- 2, 5, 6: Plating removing system
- 3: Plating immersing part
- 10: Coating apparatus
- 120, 120': Inkjet part
- 30: Supplying part
- 31: Heating apparatus
- 31A: First heating part
- 31B: Second heating part
- 32: Tank part
- 34: Delivering part
- 140: Control part
- 141: First rotationally moving part
- 142: Second rotationally moving part
- 143: Third rotationally moving part
- 50: Returning part
- 60: Temperature controlling part
- 70, 170, 270: Removing apparatus
- 71: Cooling removing part
- 72: Recovering part at cooling side
- 81: Melting removing part
- 82: Recovering part at melting side
- A: Coating material
- A': Masking agent
- F: Fluid
- M: Metal layer
- S: Carbonization surface
- S1: Treating surface
- S2: Non-treating surface
- W: Object to be coated

## Claims

1. A method for producing a surface treated base, comprising:
a process of preparing a masking solution by heating a masking agent including paraffin to a temperature more than the melting point of the paraffin;
a process of patterning the masking solution on a substrate to form a mask pattern;
a process of surface treating the substrate having the mask pattern; and
a process of producing the surface treated base by removing the masking agent constituting the mask pattern using a refrigerant having a temperature less than the melting point of the paraffin.

2. The method for producing a surface treated base of claim 1, comprising:
a process of preparing a masking solution by heating a masking agent including paraffin to a temperature more than the melting point of the paraffin;
a process of patterning the masking solution on a substrate to form a mask pattern;
a process of plating treating the substrate having the mask pattern to form a metal layer where no mask pattern is formed; and
a process of removing the masking agent constituting the mask pattern using a refrigerant having a temperature less than the melting point of the paraffin.

3. The method for producing a surface treated base of claim 1, comprising:
a process of preparing a substrate with a metal layer formed on the surface thereof;
a process of preparing a masking solution by heating a masking agent including paraffin to more than the melting point of the paraffin;
a process of patterning the masking solution on the metal layer to form a mask pattern;
a process of etching the substrate having the mask pattern; and
a process of removing the masking agent constituting the mask pattern using a refrigerant having a temperature less than the melting point of the paraffin.

4. The producing method according to any one of claims 1 to 3, further comprising a process of recovering the masking agent removed by the refrigerant.

5. The producing method of claim 4, wherein the process of recovering is conducted by floating the removed masking agent in a neutral liquid having higher specific gravity than the masking agent.

6. The producing method according to any one of claims 1 to 5, wherein the refrigerant is a neutral liquid and/or cold air.

7. The producing method of claim 6, wherein the refrigerant is water.

8. The producing method of claim 7, wherein the refrigerant is pure water.

9. The producing method according to any one of claims 1 to 8, wherein the process of forming the mask pattern comprises a process of coating the masking solution on the substrate heated to or heat-retained at about 40-50°C.

10. The producing method according to any one of claims 1 to 9, wherein the process of forming the mask pattern comprises a process of coating the masking solution on the substrate and a process of heating the substrate coated with the masking solution to about 70-110°C.

11. The producing method according to any one of claims 1 to 10, wherein the process of removing the masking agent is conducted by cooling the mask pattern and removing the masking agent using a refrigerant having a temperature less than the melting point of the paraffin.

12. The producing method according to any one of claims 1 to 11, wherein the patterning of the masking solution is conducted by an inkjet method.

13. The producing method according to any one of claims 1 to 12, wherein the masking agent further comprises a colorant.

14. A method of forming a mask pattern, comprising:
a process of preparing a masking solution by heating a masking agent including paraffin to a temperature more than the melting point of the paraffin; and
a process of pattering the masking solution on a substrate to form a mask pattern.

15. The method of forming a mask pattern of claim 14, wherein the process of forming the mask pattern comprises a process of coating the masking solution on the substrate heated to or heat-retained at about 40-50°C.

16. The method of forming a mask pattern of claim 14 or 15, wherein the process of forming the mask pattern comprises a process of coating the masking solution on the substrate and a process of heating the substrate coated with the masking solution to about 70-110°C.

17. A masking agent comprising paraffin.

18. The masking agent of claim 17, wherein a viscosity of the masking agent at about 80°C is about 5-30 mPa·s.

19. The masking agent of claim 17 or 18, further comprising a colorant.

20. The masking agent according to any one of claims 17 to 19, wherein an amount of the paraffin is from about 80 wt% to about 100 wt% with respect to a total amount of the masking solution.

21. A masking agent consisting of paraffin.
